(19) Europäisches Patentamt
European Patent Office
Office européen des brevets

(11) EP 3 500 983 B1

(12) # EUROPEAN PATENT SPECIFICATION

(45) Date of publication and mention of the grant of the patent:
**10.01.2024 Bulletin 2024/02**

(21) Application number: **17758733.4**

(22) Date of filing: **17.08.2017**

(51) International Patent Classification (IPC):
***G06N 10/40*** *(2022.01)* *G06N 10/70* *(2022.01)*

(52) Cooperative Patent Classification (CPC):
**G06N 10/40;** G06N 10/70

(86) International application number:
**PCT/US2017/047417**

(87) International publication number:
**WO 2018/035360 (22.02.2018 Gazette 2018/08)**

(54) **QUANTUM COMPUTING DEVICES WITH MAJORANA QUBITS**

GERÄTE DER ELEKTRONISCHEN DATENVERARBEITUNG MIT EINEM QUANTENCOMPUTER MIT MAJORANAQUBITS

APPAREILS D’INFORMATION QUANTIQUE AVEC QUBITS MAJORANA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.08.2016 US 201662376386 P**
**23.08.2016 US 201662378218 P**
**31.08.2016 US 201662382253 P**
**27.06.2017 US 201715634983**
**28.06.2017 US 201715636376**

(43) Date of publication of application:
**26.06.2019 Bulletin 2019/26**

(73) Proprietor: **Microsoft Technology Licensing, LLC**
**Redmond, WA 98052-6399 (US)**

(72) Inventors:
- **FREEDMAN, Michael**
**Redmond, Washington 98052 (US)**
- **NAYAK, Chetan**
**Redmond, Washington 98052 (US)**
- **LUTCHYN, Roman**
**Redmond, Washington 98052 (US)**
- **KARZIG, Torsten**
**Redmond, Washington 98052 (US)**
- **BONDERSON, Parsa**
**Redmond, Washington 98052 (US)**

(74) Representative: **CMS Cameron McKenna Nabarro Olswang LLP**
**Cannon Place**
**78 Cannon Street**
**London EC4N 6AF (GB)**

(56) References cited:
**US-A1- 2014 221 059**

- **S. PLUGGE ET AL: "Roadmap to Majorana surface codes", PHYSICAL REVIEW B, vol. 94, no. 17, 28 June 2016 (2016-06-28) , page 78, XP055421238, ISSN: 2469-9950, DOI: 10.1103/PhysRevB.94.174514**
- **JASON ALICEA ET AL: "Non-Abelian statistics and topological quantum information processing in 1D wire networks", ARXIV.ORG, CORNELL UNIVERSITY LIBRARY, 201 OLIN LIBRARY CORNELL UNIVERSITY ITHACA, NY 14853, 23 June 2010 (2010-06-23), XP080484899, DOI: 10.1038/NPHYS1915**
- **L.A. LANDAU ET AL: "Towards Realistic Implementations of a Majorana Surface Code", PHYSICAL REVIEW LETTERS, vol. 116, no. 5, 1 February 2016 (2016-02-01), XP055421244, US ISSN: 0031-9007, DOI: 10.1103/PhysRevLett.116.050501**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- PARSA BONDERSON: "Measurement-only topological quantum computation via tunable interactions", PHYSICAL REVIEW. B, CONDENSED MATTER AND MATERIALS PHYSICS, vol. 87, no. 3, 10 January 2013 (2013-01-10), page 67, XP055422947, US ISSN: 1098-0121, DOI: 10.1103/PhysRevB.87.035113

## Description

## FIELD

This application relates generally to quantum computers. More specifically, the application concerns topologically protected quantum circuits.

S. Plugge et al: "Roadmap to Majorana Surface codes", Physical Review B, vol. 94, no. 17, 28 June 206, page 78, XP055421238, ISSN: 2469-995-, DOI: 10.1103/PhysRevB.94.174514 describes how surface codes offer a very promising avenue towards fault-tolerant quantum computation. Two-dimensional interacting networks of Majorana bound states in topological superconductor /semiconductor heterostructures are disclosed as well as how topologically protected logical qubits in this Majorana surface code architecture can be defined, initialized, manipulated, and read out. All physical ingredients needed to implement these operations are routinely used in topologically trivial quantum devices. Plugge et al further disclose how, by quantum interference terms in linear conductance measurements, composite single-electron pumping protocols, and gate-tunable tunnel barriers, the full set of quantum gates required for universal quantum computation can be implemented.

Jason Alicea et al describe in "Non-Abeliean statistics and topological quantum informatin processing in 1D wire networks", ARXIV.ORG, Cornell University Library, 201 Olin Library, Cornell University Ithaca, NY 14853, 23rd June 2010, XP080484899 DOI: 10. 1038/NPHYS1915 how topological quantum computing provides an elegant way around decoherence by encoding quantum information in a non-local fashion that the environment finds difficult to corrupt. Alicea et al disclose how braiding on non-Abelian anyons can be implemented in one-dimensional semiconductor wire networks. Previous work provided a recipe for driving semiconducting wires into a topological phase supporting Majorana fermions that can store topologically protected quantum information. Marjorana fermions in this setting can be transported, created, and fused by applying locally tunable gates to the wire. A network of such wires allow braiding of Majorana fermions which exhibit non-Abelian statistics in vortices like a p + *i*p superconductor. Various experimental set-ups are proposed by Alicea to enable Majorana fusion rules to be probed, along with networks that allow for efficient exchange of arbitrary numbers of Majorana fermions.

L.A. Landau et al: "Towards Realistic Implementations of a Majorana Surface Code", Physical Review Letters, vol. 116, no. 5, 1 February 2016, XP055421244, US ISSN: 0031-9007, DOI: 10.1103/PhysRevLett. 116.050501 describes how surface codes are promising candidates for quantum information processing. By building on the idea of realizing the physical qubits of a quantum information system in terms of Majorana bound states supported by topological semiconductor nanowires, basic code operations, such as projective stabilizer measurements and qubit manipulations, can be implemented by conventional tunnel conductance probes and charge pumping via single-electron transistors.

## SUMMARY

The invention is defined in the appended independent claims. Embodiments of the invention are defined in the appended dependent claims.

Various forms of a modular unit for a topologic qubit and of scalable quantum computing architectures using such modular units are disclosed herein. For example, one form is a modular unit for a topological qubit comprising six Majorana zero modes (MZMs) on a mesoscopic superconducting island. These units can provide the computational MZMs with protection from quasiparticle poisoning. Several possible realizations of these modular units are described herein. Also disclosed herein are example designs for scalable quantum computing architectures comprising the modular units together with gates and reference arms (e.g., quantum dots, Majorana wires, etc.) configured to enable joint parity measurements to be performed for various combinations of two or four MZMs associated with one or two modular units, as well as other operations on the states of MZMs.

## BRIEF DESCRIPTION OF THE DRAWINGS

Figure 1 is a schematic block diagram of an example two-sided Majorana Hexon qubit.
Figure 2 is a schematic block diagram of an example two-sided Maj orana Hexon qubit with a reference arm.
Figure 3 is a schematic block diagram of an example network of two-sided Majorana Hexon qubits.
Figure 4 is a schematic block diagram of an example one-sided Majorana Hexon qubit.
Figure 5 is a schematic block diagram of an example network of one-sided Majorana Hexon qubits.
Figure 6 is a schematic block diagram showing symmetry of an example one-sided Majorana Hexon qubit layout.
Figure 7 is a schematic block diagram showing an example network of linear Majorana Hexon qubits. Figures 8-16 are diagrams illustrating further example Hexon configurations.

Figure 17 is a schematic block diagram of a quantum device.

Figure 18 is a graph showing the dependence of the four lowest energy eigenvalues (measured in units of *t*) vs. $\delta$ for the **even** parity ground state degeneracy splitting for an example configuration discussed herein.

Figure 19 is a graph showing the dependence of the four lowest energy eigenvalues (measured in units of *t*) vs. $\delta$ for the **odd** parity degenerate ground states for an example configuration discussed herein.

Figure 20 is a graph showing the lowest eigenvalues as a function of the gate charge offset $\delta_{dot}$ for **even** joint parity for an example configuration discussed herein.

Figure 21 is a graph showing the lowest eigenvalues as a function of the gate charge offset $\delta_{dot}$ for **odd** joint parity for an example configuration discussed herein.

Figure 22 is a graph showing the relative difference in quantum capacitances $\nu_Q$ for even and odd joint parity states as a function of *t* for an example configuration discussed herein.

Figure 23 is a schematic layout of another example device for joint parity measurement.

Figure 24 is a schematic layout of yet another example device for joint parity measurement.

Figure 25 is a flowchart for operating a quantum system.

Figure 26 is another flowchart for operating a quantum system.

## DETAILED DESCRIPTION

### I. GENERAL CONSIDERATIONS

Disclosed herein are representative embodiments of apparatuses for topological quantum devices, and in particular for topologic qubits as can be used in a topological quantum computer.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed methods can be used in conjunction with other methods.

Various alternatives to the examples described herein are possible. For example, some of the methods described herein can be altered by changing the ordering of the method acts described, by splitting, repeating, or omitting certain method acts, etc. The various aspects of the disclosed technology can be used in combination or separately.

As used in this application and in the claims, the singular forms "a," "an," and "the" include the plural forms unless the context clearly dictates otherwise. Additionally, the term "includes" means "comprises." Further, as used herein, the term "and/or" means any one item or combination of any items in the phrase.

### II. OVERVIEW

Various forms of a modular unit for a topologic qubit and of scalable quantum computing architectures using such modular units are disclosed herein. For example, one form is a modular unit for a topological qubit comprising six Majorana zero modes (MZMs) on a mesoscopic superconducting island. Such a modular unit is sometimes referred to herein as a "Majorana Hexon qubit." These units can provide the computational MZMs with protection from quasiparticle poisoning. Several possible realizations of these modular units are described herein. Also disclosed herein are example designs for scalable quantum computing architectures comprising the modular units together with gates and reference arms (e.g., quantum dots, Majorana wires, etc.) configured to enable joint parity measurements to be performed for various combinations of two or four MZMs associated with one or two modular units, as well as other operations on the states of MZMs. These can be configured in such a way to allow the generation of all the Clifford gates with topological protection and non-Clifford gates (e.g., a $\pi$/8-phase gate) without topological protection, thereby producing a computationally universal gate set. Several possible realizations of these architectures are disclosed.

While the figures depict realizations of MZMs at the endpoints of nanowires, the principles of the disclosed technology can also apply to more general realizations of MZMs (e.g., 2DEGs) and are not specifically limited to nanowire realizations.

Further, while the embodiments discussed below focus on six MZMs per superconducting island, larger numbers of MZMs per island are also possible.

Certain embodiments of the disclosed modular units lead to planar, two-dimensional, connected networks of qubits. Further, certain embodiments of the disclosed technology provide great flexibility in Hexon manipulations (via braiding of Majoranas) through the presence of an extra ancilla. In further embodiments, the ancillas in the network are integrated (and shared between one or more Hexons) in such a manner that additional ancillas are not necessary. For instance, in some emobdiments, each Hexon can be manipulated or entangled with other Hexons without the need of additional qubits that would act as ancillas.

Other architectures with which the disclosed technology can be used, are described in T. Karzig et al., "Scalable Designs for Quasiparticle-Poisoning-Protected Topological Quantum Computation with Majorana Zero Modes," arXiv: 1610.05289 (March 2017); T. Karzig et al., "Scalable Designs for Quasiparticle-Poisoning-Protected Topological Quantum Computation with Majorana Zero Modes," Phys. Rev. B 95, 235305 (2017); and U.S. Nonprovisional Application No. 15/634,983, entitled "MEASURING AND MANIPULATING STATES OF NON-ABELIAN QUASIPARTICLES VIA QUANTUM DOT HYBRIDIZATION ENERGY SHIFTS" filed on June 27, 2017.

These and other examples will be explained in more detail in the description below.

III. MAJORANA HEXON QUBITS

One example disclosed herein is a modular unit comprising six MZMs situated on a single mesoscopic superconducting island. When the charging energy $E_c$ of the island is large, it provides the contained MZMs protection from quasiparticle poisoning.

Systems with MZMs are often referred to as "topological" or "topologically protected," but, more precisely, they are "symmetry protected topological," as detailed in Phys. Rev. B 87, 195451 (2013) [arXiv: 1212.6395]. In particular, their topological protection is based on fermion parity symmetry, meaning the system's fermion parity must be preserved in order to manifest topological protection of the states encoded nonlocally in the MZMs. Consequently, MZM systems are potentially vulnerable to stray electrons entering MZMs from outside the system - a quasiparticle poisoning. Such events constitute errors for quantum information encoded in the (nonlocal) fermion parities of MZMs. In particular, they take qubits out of the computational subspace, since they flip the fermion parities associated with the MZMs. Hence, it is desirable to protect MZM systems used for quantum computation from quasiparticle poisoning.

Six is the smallest number of MZMs that supports the combination of one computational qubit (which is encoded in four of the MZMs) and one ancillary pair of MZMs. This combination is particularly useful because the presence of an ancillary pair makes it possible to generate braiding transformations using the "measurement-only" protocols detailed in U.S. Patent #8209279: "Measurement-Only Topological Quantum Computation" and papers Phys. Rev. Lett. 101, 010501 (2008) [arXiv:0802.0279] and Annals Phys. 324, 787-826 (2009) [arXiv:0808.1933] or the tunable couplings methods, details of which can be found in e.g. Phys. Rev. B 87, 035113 (2013) [arXiv:1210.7929] and Phys. Rev. B 88, 035121 (2013) [arXiv: 1303.4379]. In other words, one can perform sequences of topological charge (joint parity) measurements or sequences of tuning couplings, rather than physically transporting the MZMs in order to generate the braiding transformations on the qubit states encoded in MZMs. Thus, using the modular unit (a Majorana Hexon qubit) together with the ability to perform measurements of certain pairs of MZMs and/or the ability to control the tuning of couplings between the pairs of MZMs, one can generate the single-qubit Clifford gates with topological protection, while simultaneously protecting the qubit from quasiparticle poisoning errors.

The joint fermion parity measurements of MZMs may be implemented, for example, by conductance measurements, as described in Phys. Rev. Lett. 116, 050501 (2016) [arXiv:1509.05345], or quantum dot spectroscopy, as described in U.S. Provisional Patent Application 62/378,218 and U.S. Provisional Patent Application 62/376,386. In this disclosure, the focus is primarily on measurement-only implementations of the braiding transformations, but it should be recognized that the braiding transformations can equivalently be performed by adiabatic evolution via changing Majorana couplings.

Spanning the full set of single-qubit Clifford gates on a given Majorana Hexon qubit (or the full set of braiding transformations for the non-ancillary MZMs on an island) involves a minimal set of pairs of MZMs upon which one can perform joint parity measurements. An efficient implementation follows from allowing measurements of each pair of MZMs within an island, though a subset of the pairs is sufficient. Practical constraints may limit or constrain which pairs can be measured.

Moreover, these modular units (Majorana Hexon qubits) are also compatible with generating entangling gates, e.g., two-qubit Clifford gates, while simultaneously protecting the qubits from quasiparticle poisoning, through the use of joint parity measurements of 4 MZMs (2 MZMs from one Majorana Hexon qubit unit and 2 from another). Together with the single qubit Clifford gates, these generate all (n-qubit) Clifford gates. More details on how such measurements generate the Clifford gates can be found in the "Appendix A - Hexon Details" section below. It should be noted that, as long as one is able to perform the appropriate measurements of MZMs, one ancillary pair of MZMs on an island is sufficient for implementing entangling gates between two qubits on separate islands (between two Majorana Hexon qubits), without the need of extra ancillary MZMs, as detailed in the "Appendix A - Hexon Details" section below.

It is known that the Clifford gates by themselves do not form a computationally universal gate set, but that supplementing the Clifford gates with a non-Clifford 1-qubit gate, e.g. the $\pi/8$-phase gate yields a computationally universal gate set. Such a gate can be produced from "magic states" by using measurements. Magic states can be generated in a number of ways for Majorana systems. The apparatuses used to perform measurements and/or tune couplings of MZMs mentioned in this disclosure can be used to generate magic states. (These magic states will not be topologically protected, so they will likely require some error-correction, e.g. by magic state distillation methods of Phys.

Rev. A 71, 022316 (2005) [quant-ph/0403025]; if desired, one can also utilize cancelation schemes, such as those detailed in Phys. Rev. X 6, 31019 (2016)[arXiv:1511.05161] to improve the fidelity of magic state generation, before distillation.) Example methods of generating magic states with the described apparatus include the partial interferometry methods detailed in U.S. Patent #9256834: "Quantum Computers Having Partial Interferometric Quantum Gates" and the following discussion of performing measurements of non-Pauli operators.

The next sections described in more detial several possible architectures for realizing Majorana Hexon qubits in accordance with the disclosed technology.

## IV. TWO-SIDED MAJORANA HEXON QUBIT

In accordance with one embodiment, the two-sided Majorana Hexon qubit comprises three one-dimensional topological superconductors (1DTSs) (e.g. half-shell Al-coated InAs nanowires) that are joined by a superconducting "backbone." For purposes of this discussion and without limitation, the horizontal direction is defined to be along the length of the 1DTSs and the vertical direction to be along the length of the backbone (perpendicular to the 1DTSs). The backbone effectively joins the three 1DTSs to form a single island. (The directional orientations used herein are for explanatory purposes, as the disclosed embodiments can be rotated into different orientations.)

Figure 1 is a schematic block diagram 100 illustrating this configuration. In the figures, and in addition to the color coding, reference numbers or symbols are provided to designate the various components in accordance with the key at the bottom of each figure (e.g., s-wave superconductors 112, half-shell topological wires (or p-wave superconductors) 110, and Majorana zero mode (labelled "x")). In some cases for ease of illustration, and usually with respect to the half-shell topological wire (or P-wave superconductor) on which the MZMs reside, only a few examples of the components are highlighted by reference numbers even though additional instances of the component are illustrated in the figure. One skilled in the art will recognize those additional instances based on the example reference numbers illustrated.

The separate charging energy of the 1DTSs is exponentially suppressed by the number of channels that connect the 1DTSs to the backbone. The typical number of channels in the superconductor of half-shell nanowire realizations is expected to be larger than 1000.

The MZMs reside at the ends of the 1DTSs of length L. The remaining hybridization splitting between MZMs will be exponentially suppressed by exp ($-L/\xi$), where $\xi$ is the effective coherence length in the 1DTSs. Note that for a short backbone, $L$ not only controls the hybridization within a 1DTS, but also between MZMs of different 1DTSs (for a sufficiently insulating substrate).

A two-sided Majorana Hexon qubit may comprise 1DTSs that are closely spaced in the vertical direction, but long in the horizontal direction (to minimize unwanted hybridization). (Again, the directional orientations used herein are for explanatory purposes, as the disclosed embodiments can be rotated into different orientations.) Close vertical spacing allows easy access for measurements on any two of the three nearby MZMs on a given side (left or right) of the two-sided Majorana Hexon qubit. In particular, , a measurement scheme can be employed where each of the ends of the 1DTSs can be connected to (and disconnected from) a semiconducting wire that is aligned perpendicular to the 1DTSs, as shown in schematic block diagram 300 of Figure 3. The connection can be tuned by depletion gates. An additional set of gates can split the semiconducting wire into separate quantum dots with full control over the coupling strength between these quantum dots. This setup therefore allows the connection of any two MZMs to coupled quantum dots. The measurement then proceeds by using the quantum dots as input and output for conductance measurements or directly probing the energy levels of the quantum dots (in the latter case also using a single dot suffices).

As mentioned above, measuring pairs within the groups of three nearby MZMs (on the left or right of the unit) is desirably complemented by measurements of pairs of MZMs selected from the opposite sides of the unit, which are separated by a distance of the order $L$. These long-distance measurements can be implemented by adding a coherent reference arm of length $L$ (for example in the form of an additional, isolated 1DTS), as shown in schematic block diagram 200 in Figure 2. When the reference arm is coupled to the vertical semiconducting wire by similar controls as the three connected 1DTSs, the flexibility of selectively coupling any of the nearby MZMs to the vertical semiconducting wire allows for performing all long-distance measurements. If the distance of the MZMs to the reference arm becomes an issue for the visibility of the measurement, it is also possible to only perform long-distance measurements involving MZMs that are at most twice the distance between neighboring 1DTSs apart from the reference arm. Note that another way of performing the long-distance measurements becomes possible if the backbone can be selectively weakened to (at least) partially disconnect one of the 1DTSs from the other two. In that case, the separate charging energy of the disconnected 1DTS splits the two fermionic parity states of the MZMs on the corresponding 1DTS, which allows for a measurement via charge sensing.

Entangling gates can be implemented by operations that include measurements of the joint parity of 4 MZMs, two from each qubit (on different islands). Again, these measurements are possible via conductance or spectroscopic measurements. Such 4 MZM measurements involving two horizontally adjacent two-sided Majorana Hexon qubits (denoted by left and right) can be performed by using the same vertical semiconducting wire at the right end of the left two-sided Majorana Hexon qubit and the left end of the right two-sided Majorana Hexon qubit, as seen in Figure 3. The two dots used in the measurement would both be defined within the vertical semiconducting wire, and would be disconnected except for one hybridization path through MZMs of the left Hexon qubit and another through MZMs of the right Hexon qubit. A 4 MZM measurement involving two vertically adjacent two-sided Majorana Hexon qubits (denoted upper and lower) can be performed by making the vertical semiconducting wire extended such that the upper and lower two-sided Majorana Hexon qubits share an uninterrupted part of the semiconducting wire. One of the dots used in the measurement would then be defined on the left shared vertical semiconducting wire, while the other is on the right shared vertical semiconducting wire. For these measurements, extra reference arms would be disconnected from the two-sided Majorana Hexon qubits so that the two measured qubits can only hybridize via the upper or lower MZM states.

## V. ONE-SIDED MAJORANA HEXON QUBIT

An one-sided Majorana Hexon qubit comprises 6 1DTSs (of length L) that are connected by a superconducting backbone at one side (backbone side). Figure 4 is a schematic block diagram 400 illustrating this one-sided Majorana Hexon qubit. The short vertical distance between neighboring 1DTS can lead to a strong hybridization of the 6 MZMs located at the backbone side of the 1DTSs, effectively leaving only 6 MZMs at the other side (MZM side). One advantage of this design over the two-sided Majorana Hexon qubit is that it provides topological protection of the MZMs corresponding to length 2*L*, rather than *L*, for 1DTSs of length *L*. Since the capacitance of wires (with length much larger than the diameter) grows linearly with length, but only logarithmically with diameter, it is estimated that in the elongated design of Majorana Hexon qubits, the capacitance will be decreased when the islands are made half as long, while doubling the width. The one-sided Majorana Hexon qubit is therefore a way to increase the charging energy of the 6-Majorana islands (which increases the protection from quasiparticle poisoning).

Aside from possible changes in the overall charging energy of each island, operations for one-sided Majorana Hexon qubits can be implemented in a very similar manner as for the two-sided Majorana Hexon qubits. The Majorana side of the island is again connected to a vertical semiconducting wire that can be gated into quantum dots with tunable connections of the resulting quantum dots to the 6 MZMs. Since all 6 MZMs are now located at the same side, there are no long distances of the order of *L* between any pair of MZMs. This allows one to measure the joint fermionic parity of any pair of the 6 MZMs (similar to the situation for the three MZMs at each side of the two-sided Majorana Hexon qubit), without the need of a long (length of order *L*) reference arm.

An example network of one-sided Majorana Hexon qubits can comprise pairs of one-sided Majorana Hexon qubits (one-sided pairs) aligned at the backbone side, with the Majorana side of the left one-sided Majorana Hexon qubit being on the left and the Majorana side of the right one-sided Majorana Hexon Qubit being on the right. In one particular embodiment, one reference arm of length 2*L* is located above and below a one-sided pair, as shown in schematic block diagram 500 of Figure 5. This structure can then be repeated in the vertical direction, forming a vertical column in the array. The adjacent vertical columns can be vertically displaced by 4 1DTSs, as shown in Figure 5. This way, the right part of the one-sided pair can connect (via the upper two MZMs) to the lower two MZMs of a one-sided Majorana Hexon qubit in the adjacent vertical column. Similarly, the lower two MZMs can connect to the upper two MZMs of a one-sided Majorana Hexon qubit in the adjacent vertical column. These connections allow operations (e.g., joint parity measurements of 4 MZMs) that entangle the right part of each column with the left part of the next column. In order to also allow connections between the right and left part of each vertical column, the above mentioned extra reference arms can be used. The latter connect the right part of a one-sided pair with the left part of the one-sided pair of the next-to-nearest column (at the same horizontal position). The right and the left parts of the jth column are now connected to each other through their respective connections to the left part of the $j$ + 1th column and the right part of the $j$ - 1th column, which are in turn connected to each other (see Figure 5). Thus, a fully connected array can be constructed, as shown in Figure 5 and in schematic block diagram 600 in Figure 6.

## VI. LINEAR MAJORANA HEXON QUBIT

A linear Majorana Hexon qubit comprises one long 1DTS (length *L*) that is partitioned into three topological superconducting regions separated by two normal non-topological (s-wave) superconducting regions. Figure 7 is a schematic block diagram 700 illustrating an example of a network of linear Majorana Hexons. The non-topological superconducting regions can be created from a long 1DTS by gating. Since gating does not affect the superconducting part, the superconducting "backbone" is naturally provided by the normal regions of the 1DTS that connect the three topological superconducting regions, effectively forming a one-dimensional island. (In a realization of half-shell wires, the superconducting backbone would be the superconducting shell that is present throughout the entire half shell wire of length *L*.) In order for the system to realize MZMs at the end of the topological superconducting regions, the lengths $L_{top}$ of the topological superconducting regions as well as the lengths $L_{normal}$ of the normal superconducting regions are desirably sufficiently long as compared with the respective coherence lengths of these regions, e.g. $L_{top} \gg \xi_{top}$ and $L_{normal} \gg \xi_{normal}$. Assuming $\xi_{top} \approx \xi_{normal}$ and $L_{region} = L_{top} \approx L_{normal}$, so that the overall length of the one-dimensional island is $L = 5L_{region}$, this configuration provides topological protection of the MZMs corresponding to $L_{region} = L/5$. From similar arguments as in the previous section, the charging energy of linear Majorana Hexon qubits is smaller than both the two-sided and one-sided versions of Majorana Hexon qubits. A possible advantage of the linear Majorana Hexon qubit design is the absence of an additional structure to provide the superconducting backbone.

Due to the linear layout of this design, there are no MZM pairs that are not separated by at least $L_{top}$ or $L_{normal}$. In this sense, measurements cannot be performed by coupling nearby MZMs, as was used in the previous designs. Instead, all measurements require reference arms of sufficient length. One example layout, shown in Figure 7, uses reference arms of length $L_{top} + L_{normal}$. The configuration of reference arms shown in Figure 7 allows one to measure the joint parity of the following pairs of the MZMs on a given Hexon unit, labeled 1 to 6 from left to right: (1, 2), (1, 3), (2, 3), (3, 4), (3, 5), and (4, 5). Additionally, the configuration of reference arms allows one to measure the joint parity of the group of 4 MZMs composed of: (*L*5, *L*6, *R*1, *R*2) for two horizontally adjacent linear Majorana Hexon qubits (*L* and *R* indicating the left and right unit, respectively); and either (*U*5, *U*6, *D*5, *D*6) or (*U*3, *U*4, *D*3, *D*4) for two vertically adjacent linear Majorana Hexon qubits (*U* and *D* indicating the upper and lower unit, respectively), depending on which rows of the array the qubits are in. These operations are sufficient to perform all Clifford operations, as outlined in the "Appendix A - Hexon Details" section below.

## VII. QUANTUM COMPUTING DEVICE DESIGN CONSIDERATIONS

In the sections above, several designs for assembling the different types of Majorana Hexon qubits into scalable quantum computing devices were disclosed. In general, these designs comprise periodic arrays of the superconducting islands hosting 6 MZMs, together with quantum dots and reference arms that can be used to perform the desired measurements and operations on states of MZMs. The presented designs all have reasonable fabrication requirements, but they lie in different areas of design "parameter space," so the different designs may afford different advantages, e.g. in terms of fabrication and/or device characteristics and operation.

One parameter to consider is the charging energy $E_c$ of a superconducting island. Charging energy is a geometric quantity that is roughly inversely proportional to the length scale *L* of the object, e.g. $E_c \sim 1/L$. It also is affected by the local electrical environment. $E_c$ is desirably selected to balance two opposing criteria: it should be large enough to suppress quasiparticle poisoning, which may take the form of stray electrons entering the system through a MZM; and it should be small enough that the read-out signals of the measurements essential to the desired manipulation of the system are strong enough. Per U.S. Provisional Application No. 62/378,218, the quantum dot energy shifts playing a role in measurements are proportional to $1/E_c$. Other measurement protocols show a scaling $1/(E_c)^2$. In either case $E_c$ cannot be too large or the required signal will not be detectable in a short period of time (e.g. computer clock cycle). The designs disclosed herein have length scales ranging over a factor of approximately 5. The design "Linear Majorana Hexon Qubit" has the smallest, next is the "2-Sided Majorana Hexon Qubit," and largest is the "One-Sided Majorana Hexon Qubit." Other design parameters include simplicity of fabrication. In particular, the Linear Majorana Hexon Qubit has the simplicity of not requiring a strong superconducting weld (large $E_J$) joining constituent pieces. All designs can realize the Clifford gate set in an efficient manner via measurement-only methods.

The designs disclosed herein can be implemented by using well-developed building blocks in this area of micro-technology. For example, in certain embodiments, the designs can be realized by building a structure of *p*-wave superconducting nanowires (Majorana nanowires) on an insulating wafer and connecting MZMs hosted by these wires via quantum dots built from gated semiconductor overlying the wires and portions of the wafer. Wires of the required p-wave type were described in Nature Nanotechnology 10, 232 (2015) [arXiv:1411.6255] and Nature Materials 14, 400 (2015) [arXiv:1411.6254]. The example designs use MZMs that can be localized either at the ends of wires or in middle regions, where they may be created by gating an internal segment of the wire so it is tuned out of the topological regime, e.g. as described in Nature Physics 7, 412 (2011) [arXiv:1006.4395]. However, the general principles of the disclosed tec hnology and the particular designs illustrated are not limited to this style of fabrication. For example, it is also possible to fabricate our layouts by gating two dimensional electron gasses (2DEGs) and proximitizing them with a superconductor, as described in Phys. Rev. B 93, 155402 (2016) [arXiv: 1511.01127].

## VIII. FURTHER REPRESENTATIVE EMBODIMENTS

This section describes various examples of the disclosed technology.

The disclosed examples include examples of a symmetry-protected-topological and quasiparticle-poisoning-protected Majorana Hexon qubit.

For instance, one example as described herein is a two-sided Majorana Hexon qubit, comprising: three topological superconducting nanowires, each of the topological superconducting nanowires having a respective first end at which a respective first Majorana zero mode resides and a respective second end, opposite the first respective end, where a respective second Majorana zero mode resides; and a superconducting backbone element connected to the three topological superconducting nanowires, the superconducting backbone element being located between the respective first ends and the respective second ends of the three topological superconductive nanowires. In some implementations, the three topological superconducting nanowires are located on a superconducting island having a charging energy sufficient to prevent quasiparticle poisoning.

In some examples, the superconducting backbone element is oriented transverse to the three topological superconducting nanowires. In further examples, the three topological superconducting nanowires are half-shell topological wires or p-wave superconductors, and wherein the superconducting backbone element is an s-wave superconductor.

In some examples, the two-sided Majorana Hexon qubit further comprises a fourth topological superconducting nanowire selectively coupled to the respective first ends of the three topological superconducting nanowires and having a second end selectively coupled to the respective second ends of the three topological superconducting nanowires. In such embodiments, the first end of the fourth topological superconducting nanowire is selectively coupled to the respective first ends of the three topological superconducting nanowires via a first-end semiconductive wire, and the second end of the fourth topological superconducting nanowire is selectively coupled to the respective second ends of the three topological superconducting nanowires via a second-end semiconductive wire.

In further examples, the two-sided Majorana Hexon qubit of can further comprise a set of first-end depletion gates arranged to provide selective quantum-dot couplings between the fourth topological superconducting nanowire and any one or more of the first ends of the three topological superconducting nanowires via the first-end semiconductive wire; and a set of second-end depletion gates arranged to provide selective quantum-dot couplings between the fourth topological superconducting nanowire and any one or more of the second ends of the three topological superconducting nanowires via the second-end semiconductive wire.

Further embodiments comprise a network comprising multiple instances of any of the two-sided Majorana Hexon qubits disclosed. In such embodiments, at least one of the first-end semiconductive wire or the second-end semiconductive wire is shared with one or more neighboring instances of the two-sided Majorana Hexon qubit. The one or more neighboring instances of the two-sided Majorana Hexon qubit are neighboring along a horizontal direction, a vertical direction, or both.

Another example as described herein is a one-sided Majorana Hexon qubit, comprising: six topological superconducting nanowires, each of the topological superconducting nanowires having a respective Majorana-zero-mode (MZM) end at which a respective first MZM resides and a respective backbone end opposite the MZM end; and a superconducting backbone element connected to the six topological superconducting nanowires, the superconducting backbone element being connected to the six topological superconducting nanowire at the respective backbone ends of the six topological superconductive nanowires.

In some examples, the superconducting backbone element is oriented transverse to the six topological superconducting nanowires. In further examples, the six topological superconducting nanowires are half-shell topological wires or p-wave superconductors, and the superconducting backbone element is an s-wave superconductor. In certain examples, the six topological superconducting nanowires are located on a superconducting island having a charging energy sufficient to prevent quasiparticle poisoning.

Further embodiments comprise a network comprising multiple instances of any of the one-sided Majorana Hexon qubits as described above. In some embodiments, a first instance and a second instance of the one-sided Majorana Hexon qubits are arranged such that their respective superconducting backbone elements face one another and their respective six MZM ends are in opposite directions from one another. In such embodiments, the network can further comprise a first reference-arm topological superconducting nanowire having a first end selectively coupled to each of the respective MZM ends of the first instance of the one-sided Majorana Hexon qubit and having a second end selectively coupled to each of the respective MZM ends of the second instance of the one-sided Majorana hexon qubit. Still further, some example implementations further comprise a second reference-arm topological superconducting nanowire having a first end selectively coupled to each of the respective MZM ends of the first instance of the one-sided Majorana Hexon qubit and having a second end selectively coupled to each of the respective MZM ends of the second instance of the one-sided Majorana hexon qubit, the second reference-arm topological superconducting nanowire being located on an opposite side of the first instance and the second instance of the one-side Majorana Hexon qubit than the first reference-arm topological superconducting nanowire.

In some examples, the first end of the first reference-arm topological superconducting nanowire is selectively coupled to each of the respective MZM ends of the first instance of the one-sided Majorana Hexon qubit via a first-end semiconductive wire, and the second end of the first reference-arm topological superconducting nanowire is selectively coupled to each of the respective MZM ends of the second instance of the one-sided Majorana Hexon qubit via a second-end semiconductive wire. In such examples, the network can further comprise a set of first-end depletion gates arranged to provide a selective quantum-dot coupling between the first end of the first reference-arm topological superconducting nanowire and any one or more of the MZM ends of the first instance of the one-sided Maj orana Hexon qubit via the first-end semiconductive wire; and a set of second-end depletion gates arranged to provide a selective quantum-dot coupling between the second end of the first reference-arm topological superconducting nanowire and any one or more of the MZM ends of the second instance of the one-sided Majorana Hexon qubit via the second-end semiconductive wire. In some implementations, at least one of the first-end semiconductive wire or the second-end semiconductive wire is shared with one or more neighboring instances of the one-sided Majorana Hexon qubit. The one or more neighboring instances of the one-side Majorana Hexon qubit are neighboring along a horizontal direction, a vertical direction, or both.

Further examples described herein include a linear Majorana Hexon qubit, comprising: a topological superconducting nanowire partitioned into regions, including: three MZM topological superconducting regions, each having a respective first end at which a respective first Majorana zero mode resides and a respective second end, opposite the first respective end, where a respective second Majorana zero mode resides; and two s-wave superconducting regions that separate the three MZM topological superconducting regions from one another.

In some examples, the s-wave superconducting regions are created by gating junctions between the MZM topological superconducting regions and the s-wave superconducting regions, and the topological superconducting nanowire is located on a superconducting island having a charging energy sufficient to prevent quasiparticle poisoning.

Further embodiments comprise two or more instances of the linear Majorana Hexon qubit as described above. For instance, in some example implementations, one or more neighboring instances of the linear Majorana Hexon qubit are selectively coupled to one another by superconductive reference arms having tunable depletion gates configured to provide quantum-dot couplings between the neighboring instances. In further examples, the one or more neighboring instances of the one-side Majorana Hexon qubit are neighboring along a horizontal direction, a vertical direction, or both.

## IX. APPENDIX A - HEXON DETAILS

As explained herein, the full set of single-qubit Clifford gates can be generated on the computational qubit encoded in a single hexon given an appropriate minimal set of joint parity measurements of pairs of MZMs. One can diagrammatically represent the topological state of a hexon as shown in Figure 8.

More specifically, Figure 8 is a diagrammatic representation 800 of the topological states (degenerate ground states) of a hexon. The center two MZMs $\gamma_3$ and $\gamma_4$ fuse to even fermion parity, forming the ancillary pair of MZMs. The left and right pairs of MZMs both fuse to *a* = 0 or 1, which correspond to even or odd fermion parity, respectively. These outer pairs of MZMs form the computational qubit. The fusion channel *a* labels the qubit basis state.

In Figure 8, the MZMs $\gamma_j$ with *j* = 1, . . . , 6 are labeled from left to right. The diagram may be interpreted as follows: The center two MZMs $\gamma_3$ and $\gamma_4$, forming the ancillary pair, fuse to even fermion parity ($p_{34}$ = -1). The left-most and the right-most pairs of MZMs, $\gamma_1$ and $\gamma_2$, and $\gamma_5$ and $\gamma_6$, respectively, forming the computational qubit, have the same fusion channel *a* = 0 (even fermion parity) or 1 (odd fermion parity). That is, the fusion channel *a* labels the qubit basis states

$$|0\rangle \;=\; |p_{12} = p_{56} = -1\rangle \tag{1}$$

$$|1\rangle \;=\; |p_{12} = p_{56} = +1\rangle. \tag{2}$$

The total fusion channel of the four MZMs forming the computational qubit is even fermion parity (P12P56 = 1).

In this appendix, the following equation is proven:

$$\Pi_0^{(34)}\Pi_0^{(35)}\Pi_0^{(5678)}\Pi_0^{(45)}\Pi_0^{(34)} \propto W^{(5678)} \otimes \Pi_0^{(34)}, \tag{3}$$

and it is explained how to shuttle computational MZMs through the qubit. (In the following diagrammatic analysis, unimportant overall constants are neglected.)

For the two-qubit entangling gate

$$W = \begin{pmatrix} 1 & 0 & 0 & 0 \\ 0 & i & 0 & 0 \\ 0 & 0 & i & 0 \\ 0 & 0 & 0 & 1 \end{pmatrix}, \tag{4}$$

one begins by considering the qubit basis states of two hexons in the initial configurations as shown in diagram 900 of Figure 9.

As in Figure 8, *a, b* ∈ {0, 1} label the fermion parity even or odd states of the outermost pairs of MZMs in a given hexon.

Projecting the fusion channel of MZMs 4 and 5 to vacuum (e.g., using forced measurement) results in diagram 1000 of Figure 10, where the jagged (wiggly) line denotes fusion to a fermion.

Applying the four-MZM projector $\Pi_0^{(5678)}$ to the above superposition yields block diagram 1100 of Figure 1100.

Then, projecting MZMs 3 and 5 to the vacuum channel gives diagram 1200 of Figure 1200.

This step utilizes the diagrammatic braiding relation of MZMs or Ising anyons as shown in diagram 1300 of Figure 1300.

Finally, projecting MZMs 3 and 4 to the vacuum channel gives diagram 1400 of Figure 1400, which is the desired entangling gate.

An alternative derivation of the equation introduced in this appendix above can be performed by explicitly multiplying the projectors written in terms of Majorana operators, as follows

$$\begin{aligned}
\Pi_0^{(34)}\Pi_0^{(35)}\Pi_0^{(5678)}\Pi_0^{(45)}\Pi_0^{(34)} &= \Pi_0^{(34)}\frac{1-i\gamma_3\gamma_5}{2}\frac{1-\gamma_5\gamma_6\gamma_7\gamma_8}{2}\frac{1-i\gamma_4\gamma_5}{2}\Pi_0^{(34)} \\
&= 2^{-3}\Pi_0^{(34)}\left(1-i\gamma_3\gamma_5-i\gamma_4\gamma_5+\gamma_3\gamma_4-\gamma_5\gamma_6\gamma_7\gamma_8+i\gamma_3\gamma_6\gamma_7\gamma_8-i\gamma_4\gamma_6\gamma_7\gamma_8+\gamma_3\gamma_4\gamma_5\gamma_6\gamma_7\gamma_8\right)\Pi_0^{(34)} \\
&= 2^{-3}\left(1+\gamma_3\gamma_4-\gamma_5\gamma_6\gamma_7\gamma_8+\gamma_3\gamma_4\gamma_5\gamma_6\gamma_7\gamma_8\right)\Pi_0^{(34)} \\
&= 2^{-3}\sqrt{2}\left(\frac{1+i}{\sqrt{2}}\right)\left(1+i\gamma_5\gamma_6\gamma_7\gamma_8\right)\Pi_0^{(34)} \\
&= \frac{1}{4}e^{i\pi/4}W^{(5678)}\otimes\Pi_0^{(34)}.
\end{aligned} \tag{5}$$

Here, $\Pi_0^{(34)}i\gamma_3\gamma_j\Pi_0^{(34)} = \Pi_0^{(34)}i\gamma_4\gamma_j\Pi_0^{(34)} = 0$ for j ≠ 3 or 4 and $\Pi_0^{(34)}$ projects $i\gamma_3\gamma_4 = -1$.

Finally, diagrams 1500 and 1600 of Figures 15 and 16 illustrate how the computational MZMs may be shuttled through the qubit using anyonic teleportation.

## X. APPENDIX B - MEASURING AND MANIPULATING STATES OF NON-ABELIAN QUASIPARTICLES VIA QUANTUM DOT HYBRIDIZATION ENERGY SHIFTS

### Overview

Described herein, are methods and/or devices for performing measurements and/or manipulations of the collective state of a set of Majorana quasiparticles/Majorana zero modes (MZMs). Example methods/devices utilize the shift of the combined energy levels due to coupling multiple quantum systems (e.g., in a Stark-effect-like fashion).

The example methods can be used to perform measurements of the collective topological charge or fermion parity of a group of MZMs (e.g., a pair of MZMs or a group of 4 MZMs). The example devices can be utilized in any system supporting MZMs. In certain examples, the technology is used in nanowire realizations of MZMs; accordingly, the disclosure and figures will reflect this focus though it should be understood that the technology is more generally applicable. The technology can also be used in two-dimensional realizations of Majorana nanowires, such as those described in J. Shabani et al., "Two-dimensional epitaxial superconductor-semiconductor heterostructures: A platform for topological superconducting networks," Phys. Rev. B 93, 155402 (2016).

One example method is compatible with methods that utilize charging energy to protect subsystems of MZMs from quasiparticle poisoning and methods that utilize parallel nanowire (avoiding issues regarding alignment with the magnetic field, which arise for example in T-junction geometry, as in Phys. Rev. B 88, 035121 (2013)), arXiv:1511.01127, and H. Suominen et al., "Scalable Majorana Devices," arXiv: 1703.03699.

The measurement apparatus can also be utilized to generate "magic states" that are not topologically protected and other states and operations beyond those that can be obtained using Clifford gates. This generally involves precise calibration and tuning (time-dependent) profiles of gates and couplings/tunneling amplitudes.

In examples, the device comprises: superconducting islands hosting MZMs (e.g., using Majorana nanowires that are proximitized with the superconductor); quantum dots; gates that control (among other things) charge of superconducting islands, charge of quantum dots, and tunneling couplings between the quantum dots and the MZMs. Further examples include devices that can perform measurements of the system energy (e.g., resonators for reflectometry measurements of the quantum dots). In some examples, turning on couplings between the quantum dots and MZMs induces an energy shift which is determined by state-dependent quantum charge fluctuations between two subsystems. Such an energy shift affects many observable quantities such as, for example, the charge of the quantum dots.

Methods and/or devices for performing measurements and/or manipulations of the collective state of a set of Majorana quasiparticles/Majorana zero modes (MZMs) are described, some methods/devices utilize the shift of the combined energy levels due to coupling multiple quantum systems (e.g., in a Stark-effect-like fashion). The methods can be used for performing measurements of the collective topological charge or fermion parity of a group of MZMs (e.g., a pair of MZMs or a group of 4 MZMs). The devices can be utilized in any system supporting MZMs. In certain examples, the technology is used in nanowire realizations of MZMs; accordingly, the disclosure and figures will reflect this focus though it should be understood that the technology is more generally applicable.

## Measurement process

During times when a measurement is not being performed, the couplings (tunneling amplitudes) $t_j$ (j = 1,..., 4) between the quantum dots and the MZMs can be turned off. These couplings can be controlled, for example, using pinch-off gates. The measurement of the collective state of MZMs is initiated by turning on the couplings between the quantum dots and the corresponding MZMs to be measured (e.g., by changing the gate voltage of the pinch-off gates). Once the couplings are turned on, the energy levels of the two quantum dots will be affected. In particular, there will be a coupling of the two quantum dots with each other that is mediated by the Majorana system, resulting in hybridization of the quantum states. The hybridization energy $J$ depends on the joint parity $p$ of the four MZMs involved. In general, $J = \alpha + \beta p$, with system-dependent constants $\alpha$ and $\beta$, $p = -\gamma_1\gamma_2\gamma_3\gamma_4$. Measuring the hybridized states (e.g. by measuring the energy of the system) therefore measures the joint parity $p$ of the MZMs.

The measurement of the hybridized states can be done by a suitable spectroscopy. One example of this is through the use of reflectometry. The idea is that a change in the hybridization changes the quantum capacitance of the double dot system, which is defined by the second derivative of the energy with respect to the gate voltages $V_{D1}$ or $V_{D2}$. In particular, when the system is tuned close to resonance of the two dots, the energy is very sensitive to changes in the gate voltage of one of the dots, making the system's quantum capacitance become appreciable. When sending an rf-signal through an inductor towards the gate (say $V_{D1}$), the corresponding LC circuit is changed through the quantum capacitance, which manifests in a change of the reflection of the rf-signal. The reflectometry measures this change in reflection. (See, e.g., Petersson et al. Nano Lett. 10, 2789 (2010); Colless et al, Phys. Rev. Lett. 110, 46805 (2013)). Since the quantum capacitance depends on the hybridization $J$ and, therefore, on the joint parity $p$, the reflectometry performs the desired projective measurement.

After the measurement of the hybridized states is performed, the couplings are turned off again. There is a small probability that the occupancy of the quantum dots will be different when the tunneling amplitudes are turned off at the end of the process described in the previous paragraph. This probability is suppressed by the charging energy, but it is not zero.

Various methods may potentially be employed to minimize this probability of having the undesired quantum dot occupancy state (e.g., one could optimize the gate tuning profile controlling the couplings). If the occupancy of the dots changes from the initial value, then quasiparticle poisoning has occurred. However, one can determine when this potential quasiparticle poisoning has occurred and one can correct for this occurrence. For this, one can detect whether or not the quasiparticle poisoning has occurred by performing a measurement of the charge of the (decoupled) quantum dots. To recover from such an error (when it occurs), one can repeat the process of the joint parity measurement of the 4 MZMs: for instance, one can turn on the same tunneling amplitudes between the quantum dots and the MZMs again, the hybridized states can be measured, the tunneling amplitudes can be turned off again, and then the occupancy of the dots can be measured to once again detect whether the system is in the desired state. If the occupancy of the dots returns to its initial value, then the process is complete; otherwise, the procedure can be repeated until it succeeds.

The scheme can be readily generalized to a measurement of the joint parities of any even number of MZMs. For a measurement of 2 MZMs, say $\gamma_1$ and $\gamma_2$, one would need to have a simple coupling of an ancillary pair of MZMs, $\gamma_3$ and $\gamma_4$, which have a fixed joint parity $i\gamma_3\gamma_4$ of known value. This can be induced by a coupling of $\gamma_3$ and $\gamma_4$ or by a charging energy. The measurement of $p = -\gamma_1\gamma_2\gamma_3\gamma_4$ then is equivalent to a measurement of the parity $i\gamma_1\gamma_2$. The coupled ancillary pair of MZMs and the two described quantum dots can also be combined into a single quantum dot. For joint parity measurement of 6 or more MZMs, the measurements can be performed similar to the presented scheme for measuring the joint parity of 4 MZMs by adding additional Majorana islands with finite charging energy (light blue regions labeled as "s-wave superconductor" in FIG. 17). For example a setup for a measurement of the collective state of 8 MZMs could be realized by doubling the distance of the dots and adding two more islands in between.

## Utility for quantum computing

The utility of the disclosed technology for quantum computation can be summarized as follows:
Measurements of the state (topological charge or parity) of pairs of MZMs can generate all the topologically protected braiding operations. Further details on this topic can be found, for example, in U.S. Patent #8209279: "Measurement-Only Topological Quantum Computation" and papers Phys. Rev. Lett. 101, 010501 (2008) [arXiv:0802.0279] and Annals Phys. 324, 787-826 (2009) [arXiv:0808.1933].

It is known that, for MZMs, braiding operations alone generates a proper subset of the Clifford operations. For example, in the "standard encoding" of qubits, braiding of MZMs only generates the 1-qubit Clifford gates. It is also known that supplementing braiding operations with the ability to perform measurements of the state (joint parity) of 4 MZMs allows one to generate the full set of Clifford gates with topological protection. For example, measurement of 4 MZMs allows one to change between distinct encodings of qubits and denser encodings allow one to obtain 2-qubit entangling gates. Further details in this regard can be found in U.S. Patent #8620855: "Use of Topological Charge Measurements to Change Between Different Qubit Encodings."

It is known that the Clifford gates by themselves do not form a computationally universal gate set, but that supplementing the Clifford gates with a non-Clifford 1-qubit gate, e.g. the $\pi/8$-phase gate yields a computationally universal gate set. Such a gate can be produced from "magic states" by using measurements. Magic states can be generated in a number of ways for Majorana systems. A measurement apparatus can be used to generate magic states. (These magic states will not be topologically protected, so they will likely require some error-correction, e.g. by magic state distillation methods of Phys. Rev. A 71, 022316 (2005) [quant-ph/0403025]. If desired, one can also utilize cancellation schemes, such as those detailed in Phys. Rev. X 6, 31019 (2016)[arXiv:1511.05161] to improve the fidelity of magic state generation, before distillation.) Methods of generating magic states with the described apparatus include the partial interferometry methods detailed in U.S. Patent #9256834: "Quantum Computers Having Partial Interferometric Quantum Gates" and the following discussion of performing measurements of non-Pauli operators.

In the language of the encoded qubits, the parity measurements described above correspond to projections onto eigenstates of the Pauli operators or tensor products of Pauli operators (for multi-qubit measurements). The measurement scheme can be extended to measure superpositions of Pauli operators. For example, instead of projecting onto the $X$ or $Y$ Pauli operator one could project onto $P(\phi) = \cos(\phi)X + \sin(\phi)Y$. This can be implemented, for example, by having another MZM $\gamma_0$ from the upper island that is coupled to the quantum dot. The measurement of the dot hybridization then has the effect of measurement of the MZMs' state corresponding to (approximate) projections onto the eigenstates of $(\cos(\phi)\gamma_0 + \sin(\phi)\gamma_1)\gamma_2\gamma_3\gamma_4$. Fixing the parity of $\gamma_3$ and $\gamma_4$ (as previously discussed) will then equate this measurement with the desired measurement with respect to the eigenstates of $P(\phi)$. With $\phi = \pi/4$, this scheme would project onto a magic state. An exact projection is typically achieved through some fine tuning, so experimental implementations of this measurement scheme will generally have errors that are not topologically protected.

## Summary of Joint Parity Measurement through the Quantum Dot energy shift

The Hamiltonian for the superconducting island $j$ is given by

$$H_{Cj} = E_{Cj}(Q_j - Q_{0,j})^2 + H_{\mathrm{BCS}}$$

where $Q_{0,j}$ is controlled by the gate voltage $V_{gj}$ and $H_{\mathrm{BCS}}$ is BCS Hamiltonian for the semiconductor-superconductor hybrid system. Further details of such systems can be found in Phys. Rev. Lett. 105, 077001 (2010) [arXiv:1002.4033] and Phys. Rev. Lett. 105, 177002 [arXiv:1003.1145]. The Hamiltonian for jth quantum dot (QD) reads $H_{QDj} = \Delta_j f_j^\dagger f_j$

with $\triangle_j$ being the energy splitting between even- and odd-charge states of the dot. Here $f_j^\dagger$ and $f_j$ are the creation and annihilation operators in the jth QD; $\triangle_j$ can be tuned using gate voltage $V_{QDj}$. The coupling between superconducting islands and QDs, in the low-energy approximation, acquires the following form (as described in Phys. Rev. Lett. 104, 056402 (2010)):

$$H = \sum_{j=1,3} t_j f_1^\dagger \gamma_j e^{-\phi_j/2} + \sum_{j=2,4} t_j f_2^\dagger \gamma_j e^{-\phi_j/2} + h.c.$$

where $\gamma_j$ is the self-conjugate Majorana operator, $t_j$ is the gate-tunable tunneling matrix element, and the operator $\phi_j$ is the conjugate operator to the island charge $Q_j$. Here, $\phi_1 = \phi_2$ and $\phi_3 = \phi_4$. The operator $e^{\mp i\phi_j/2}$ increases/decreases the charge of the superconducting island by one electron. In the limit $E_{Cj} \gg |t_j|$, the charge on the islands is fixed by appropriately choosing the gate voltage $V_{gj}$. Henceforth, it is assumed that $Q_{0,1} = Q_{0,2} = 0$. In this case, the fluctuations of charge occur due to virtual exchange of electrons between the islands and QDs. In the spirit of the second-order perturbation theory, one can derive an effective low-energy Hamiltonian valid at the energy scale much smaller than $E_{Cj}$. Henceforth, it is assumed, for simplicity, that $E_{C1} = E_{C2} = E_C$. After the projection to the low-energy subspace, one finds

$$H = -\frac{|t_1|^2 + |t_3|^2}{2E_C} f_1^\dagger f_1 - \frac{|t_2|^2 + |t_4|^2}{2E_C} f_2^\dagger f_2 + \frac{i}{2}\left(\frac{t_1 t_2^*}{E_C}\hat{p}_1 + \frac{t_3 t_4^*}{E_C}\hat{p}_2\right) f_1^\dagger f_2 + h.c., \quad (6)$$

where $\hat{p}_1 = i\gamma_1\gamma_2$ and $\hat{p}_2 = i\gamma_3\gamma_4$. The spectrum of this Hamiltonian clearly depends on the joint parity $p = p_1 p_2$. Indeed, explicit calculation for $t_1 = t_3 = t_4$ = It I and $t_2 = |t|e^{i\alpha}$ yields the following eigenvalues for the system:

$$E_\pm = -\frac{2|t|^2}{E_C} \pm \frac{|t|^2}{E_C}\sqrt{2 + 2p\cos\alpha}. \quad (7)$$

(The - energies correspond to the ground state and + to the excited state.) Thus, the measurement of the QD energy shift constitutes a joint parity measurement $p = -\gamma_1\gamma_2\gamma_3\gamma_4$. Further, more general, results are presented in T. Karzig et al., "Scalable Designs for Quasiparticle-Poisoning-Protected Topological Quantum Computation with Majorana Zero Modes," arXiv:1610.05289 (March 2017) and T. Karzig et al., "Scalable Designs for Quasiparticle-Poisoning-Protected Topological Quantum Computation with Majorana Zero Modes, "Phys. Rev. B 95, 235305 (2017).

## Example Implementations

In this section, an example joint parity measurement scheme using Quantum Dots (QDs) is described with further technical detail. As will be explained, the coupling of the superconducting islands to QDs leads to a measurable shift of the energy levels due to the quantum charge fluctuations between two subsystems. It is further demonstrated that the effective low-energy Hamiltonian for the device such as that pictured in FIG. 17 depends on the combined parity $\hat{P} = -\gamma_1\gamma_2\gamma_3\gamma_4$ when coupled to two quantum dots on both ends. By measuring the energy levels of the quantum dots, one can infer the eigenvalue of $\hat{P}$, an essential operation for Majorana-based topological quantum computing.

### A. Overview of Example Scheme

Consider the device shown in schematic block diagram 1700 of FIG. 17. In FIG. 17, superconducting islands 1711, 1712 correspond to s-wave superconductors with the corresponding SC phases $\phi_{1/2}$. Lines 1701, 1702, 1703, 1704 denote semiconducting nanowires proximitized by the superconductor. An in plane magnetic field allows one to tune the nanowire into a topological superconducting state with Majorana zero-energy modes at the opposite ends (shown as circles, such as circles 1721, 1722). Islands 1731, 1732 correspond to quantum dots which are coupled to the Majorana zero modes via gate-controlled barriers $t_j$. The charge on the islands and QDs can be tuned by the correspoding gate voltage $V_j$.

In FIG. 17, superconducting islands 1711, 1712 host two (or more) semiconducting nanowires . The nanowires are tuned to the topological phase by adjusting the chemical potential and magnetic field so that the nanowire hosts a Majorana zero mode (MZM) per end. See R. M. Lutchyn, J. D. Sau, and S. Das Sarma, Phys. Rev. Lett. 105, 077001 (2010); Y. Oreg, G. Refael, and F. von Oppen, Phys. Rev. Lett. 105, 177002 (2010). The nanowires labeled #1 (1701) and #2 (1702) are coupled to the quantum dots 1 (1731) and 2 (1732) at either end. Each superconducting island has appreciable charging energy $E_{Cj} = e^2/2C_{\Sigma j}$, determined by the geometrical capacitance $C_{\Sigma j}$ of the island (including the nanowires) to all other electrodes. The charge on the superconducting islands can be controlled by the gate voltage $V_{gj}$ (which determines the induced charge $Q_{gj}$). Therefore, the topological qubit comprising of superconducting islands is protected from unwanted quasiparticle tunneling (quasiparticle poisoning) by the charging energy. Indeed, at low temperature $T \ll E_C$, the probability of an excited state with an electron on the island is exponentially small ($\propto \exp(-E_C/T)$) and electron excursions to the island are only allowed for a short period of time determined by the quantum uncertainty principle $\tau \sim \hbar/E_C$. These quantum fluctuations are state dependent and, therefore, contain information about the state of a topological qubit.

**B. Theoretical Model**

This subsection describes the theoretical model for the example scheme. The Hamiltonian for the superconducting island hosting semiconductor nanowires is given by

$$H_0 = \sum_{j=1,2} H_{\mathrm{BCS},j} + H_{\mathrm{C},j} \tag{8}$$

where $H_{\mathrm{BCS},j}$ is the mean-field BCS Hamiltonian for the s-wave superconductor coupled to the nanowires. Due to the mesoscopic size of the island, there is a significant charging energy associated with it. The corresponding Hamiltonian reads

$$H_{\mathrm{C},j} = E_{C,j}(Q_{\mathrm{tot},j} - Q_{0,j})^2. \tag{9}$$

The operator $Q_{\mathrm{tot},j}$ counts the combined nanowire-superconductor charge, and the offset charge $Q_{0,j}$ is tuned by changing the voltage applied to a superconducting island. In the low-energy approximation, one can project the system to the low-energy subspace (e.g. $\varepsilon \ll \triangle_0$ with $\triangle_0$ being the bulk gap of an s-wave superconductor). In this limit, one can represent the island as a collection of Kitaev wires (see A. Y. Kitaev, Physics-Uspekhi 44, 131 (2001)) having the same SC phase $\phi$ for each island. At the special point (dimerized limit), the Hamiltonians for the Majorana wire #1 and #2 are given by

$$\begin{aligned} H_1 &= -\Delta_P \sum_{j=1}^{N-1} (c_j^\dagger - e^{i\phi_1} c_j)(c_{j+1} + e^{-i\phi_1} c_{j+1}^\dagger) \\ H_2 &= -\Delta_P \sum_{j=1}^{N-1} (d_j^\dagger - e^{i\phi_2} d_j)(d_{j+1} + e^{-i\phi_2} d_{j+1}^\dagger) \end{aligned} \tag{10}$$

In the above, $c$, $c^\dagger$ correspond to fermion operators in wire #1, while $d$, $d^\dagger$ are the fermion operators for wire #2. Here $\triangle_P$ is the induced p-wave gap. The superconducting phase of the top (bottom) wire is $\phi_1$ ($\phi_2$), and the operator $e^{i\phi 1}$ ($e^{i\phi 2}$) adds a Cooper pair to the top (bottom) island.

One can define operators that commute with $H_{1/2}$:

$$\begin{aligned} \Gamma_1^\dagger &= c_1^\dagger + e^{i\phi_1} c_1 \\ \Gamma_2^\dagger &= i(c_N^\dagger - e^{i\phi_1} c_N) \\ \Gamma_3^\dagger &= d_1^\dagger + e^{i\phi_2} d_1 \\ \Gamma_4^\dagger &= i(d_N^\dagger - e^{i\phi_2} d_N) \end{aligned} \tag{11}$$

(see for example:

$$
\begin{aligned}
[H_c, \Gamma_1^\dagger] &= -\Delta[(c_1^\dagger - e^{i\phi_1}c_1)(c_2 + e^{-i\phi_1}c_2^\dagger), c_1^\dagger + e^{i\phi_1}c_1] \\
&= -\Delta\Big((c_1^\dagger - e^{i\phi_1}c_1)[c_2 + e^{-i\phi_1}c_2^\dagger, c_1^\dagger + e^{i\phi_1}c_1] \\
&\quad + [c_1^\dagger - e^{i\phi_1}c_1, c_1^\dagger + e^{i\phi_1}c_1](c_2 + e^{-i\phi_2}c_2^\dagger)\Big) \\
&= \Delta\{c_1^\dagger - e^{i\phi_1}c_1, c_1^\dagger + e^{i\phi_1}c_1\}\left(c_2 + e^{-i\phi_1}c_2^\dagger\right) \\
&= \Delta\left(-e^{i\phi_1} + e^{i\phi_1}\right)\left(c_2 + e^{-i\phi_1}c_2^\dagger\right) = 0).
\end{aligned}
\tag{12}
$$

The operator $\Gamma_{1/2}^\dagger$ adds a charge to the island hosting wire #1, while $\Gamma_{3/4}^\dagger$ adds a charge to the island hosting wire #2. Thus, $\Gamma_i^\dagger$ does not commute with the number-conserving Hamiltonian $H_{C,1/2}$. However, the charge-neutral combination

$$\Gamma_1^\dagger\Gamma_2 = e^{-i\phi}\Gamma_1^\dagger\Gamma_2^\dagger = i(e^{i\phi_1}c_1^\dagger c_N^\dagger - e^{i\phi_1}c_1c_N + c_1c_N^\dagger - c_1^\dagger c_N) \tag{13}$$

does commute with $Q_{tot,1}$ (and similarly for $\Gamma_3^\dagger\Gamma_4$ and $Q_{tot,2}$). Furthermore, as $i\Gamma_1^\dagger\Gamma_2$ squares to one and anticommutes with $\Gamma_{1/2}$, it counts the parity of wire #1. Similarly, $i\Gamma_3^\dagger\Gamma_4$ counts the parity of wire #2. We denote these operators by

$$\hat{p}_1 = i\Gamma_1^\dagger\Gamma_2 \qquad\qquad \hat{p}_2 = i\Gamma_3^\dagger\Gamma_4. \tag{14}$$

Finally, note that $\gamma_i = e^{-i\phi_i/2}\Gamma_i^\dagger = \gamma_i^\dagger$ are the usual Majorana operators.

The eigenstates of $H_0$ have well defined total charge (wire plus superconductor) and parity for each island. Assume that $Q_{0,1/2}$ is adjusted such that the ground state has total charges $Q_1$ and $Q_2$. The five lowest energy states are given by

$$
\begin{aligned}
|0\rangle &= |Q_1, Q_2; p_1 = p_1', p_2 = p_2'\rangle \\
|1\rangle &= |Q_1 + 1, Q_2; -p_1, p_2\rangle = \Gamma_1^\dagger|0\rangle \\
|2\rangle &= |Q_1 - 1, Q_2; -p_1, p_2\rangle = \Gamma_1|0\rangle \\
|3\rangle &= |Q_1, Q_2 + 1; p_1, -p_2\rangle = \Gamma_3^\dagger|0\rangle \\
|4\rangle &= |Q_1, Q_2 - 1; p_1, -p_2\rangle = \Gamma_3|0\rangle.
\end{aligned}
\tag{15}
$$

For the moment, one can denote the energy levels as $H_0\,|i\rangle = E_i|i\rangle$.

One can rewrite the eigenstates in terms of the $\Gamma_{2/4}$ operators as follows:

$$-\hat{p}_1 |1\rangle = \left(i\Gamma_1^\dagger \Gamma_2\right) |1\rangle = \left(i\Gamma_1^\dagger \Gamma_2\right) \Gamma_1^\dagger |0\rangle$$
$$= -i\Gamma_1^\dagger \Gamma_1^\dagger \Gamma_2 |0\rangle = -ie^{i\phi_1}\Gamma_2 |0\rangle = -i\Gamma_2^\dagger |0\rangle$$
$$\Rightarrow |1\rangle = ip_1\Gamma_2^\dagger |0\rangle \tag{16}$$

Similar manipulations imply

$$-p_1 |2\rangle = -i\Gamma_2 |0\rangle \qquad \Rightarrow |2\rangle = ip_1\Gamma_2 |0\rangle \tag{17}$$

$$-p_2 |3\rangle = -i\Gamma_4^\dagger |0\rangle \qquad \Rightarrow |3\rangle = ip_2\Gamma_4^\dagger |0\rangle \tag{18}$$

$$-p_2 |4\rangle = -i\Gamma_4 |0\rangle \qquad \Rightarrow |4\rangle = ip_2\Gamma_4 |0\rangle . \tag{19}$$

Now add quantum dot Hamiltonian and the coupling between the QDs and the ends of the nanowires (*i.e.* the tunneling Hamiltonian):

$$H_{\text{dots}} = \sum_{i=1,2} \epsilon_i \left(f_i^\dagger f_i - \delta_{\text{dot},i}\right)^2 \tag{20}$$

$$H_{\text{tunn}} = -\left(t_1 f_1^\dagger c_1 + t_2 f_2^\dagger c_N + t_3 f_1^\dagger d_1 + t_4 f_2^\dagger d_N + \text{h.c.}\right) \tag{21}$$

The operators $f_i$, $f_i^\dagger$ annihilate and create fermions in the left and right quantum dots. $\varepsilon_i$ are the charging energies of the QDs and $\delta_{\text{dot},i}$ are the offset charges which we restrict to the interval $\delta_{\text{dot},i} \in (0, 1)$ so that the relevant charge states are either $|0\rangle_{\text{QD}}$ or $|1\rangle_{\text{QD}}$. Thus, a basis for the quantum dot degrees of freedom is

$$\begin{aligned}
|0\rangle_{\text{QD}} &= |n_1 = 0, n_2 = 0\rangle \\
|1\rangle_{\text{QD}} &= |n_1 = 1, n_2 = 0\rangle = f_1^\dagger |0\rangle_{\text{QD}} \\
|2\rangle_{\text{QD}} &= |n_1 = 0, n_2 = 1\rangle = f_2^\dagger |0\rangle_{\text{QD}} \\
|3\rangle_{\text{QD}} &= |n_1 = 1, n_2 = 1\rangle = f_1^\dagger f_2^\dagger |0\rangle_{\text{QD}} .
\end{aligned} \tag{22}$$

It is desirable to rewrite $H_{\text{tunn}}$ in terms of the operators $\Gamma_i$, describing our low-energy subspace. This can be done using

$$c_1 \to \frac{1}{2}\Gamma_1 \qquad c_N \to \frac{i}{2}\Gamma_2 \qquad d_1 \to \frac{1}{2}\Gamma_3 \qquad d_N \to \frac{i}{2}\Gamma_4. \tag{23}$$

After performing the projection described above, one can find the effective tunneling Hamiltonian:

$$H_{\text{tunn}}^{\text{eff}} = -\frac{1}{2}\left(t_1 f_1^\dagger \Gamma_1 + it_2 f_2^\dagger \Gamma_2 + t_3 f_1^\dagger \Gamma_3 + it_4 f_2^\dagger \Gamma_4 + \text{h.c.}\right) . \tag{24}$$

It is useful to establish what the non-zero matrix elements of the $\Gamma_i$ operators are. The basis defined in Eq. (15) is orthonormal, therefore the only non-zero matrix elements are

$$\langle 2|\,\Gamma_1\,|0\rangle = 1 \qquad \langle 0|\,\Gamma_1\,|1\rangle = 1 \tag{25}$$

$$\langle 2|\,\Gamma_2\,|0\rangle = -ip_1 \qquad \langle 0|\,\Gamma_2\,|1\rangle = ip_1 \tag{26}$$

$$\langle 4|\,\Gamma_3\,|0\rangle = 1 \qquad \langle 0|\,\Gamma_3\,|3\rangle = 1 \tag{27}$$

$$\langle 4|\,\Gamma_4\,|0\rangle = -ip_2 \qquad \langle 0|\,\Gamma_4\,|3\rangle = ip_2 \tag{28}$$

along with their hermitian conjugates. Importantly, one sees that certain matrix elements depend on the parity eigenvalues $p_1$,$p_2$.

One can also solve for the non-zero matrix elements in the quantum dot basis for the $f_i$ operators:

$$\langle 1|\,f_1^\dagger\,|0\rangle_{QD} = 1 \qquad \langle 3|\,f_1^\dagger\,|2\rangle_{QD} = 1$$

$$\langle 2|\,f_2^\dagger\,|0\rangle_{QD} = 1 \qquad \langle 3|\,f_2^\dagger\,|1\rangle_{QD} = -1$$

plus hermitian conjugates.

One can now write the effective tunneling Hamiltonian for the system shown in FIG. 17 in this basis:

$$\begin{aligned} H_{\text{tunn}}^{\text{eff}} = &-\frac{1}{2}\sum_{i,j}|i\rangle\langle i|\otimes|j\rangle\langle j|_{QD} \\ &\times\Big(t_1 f_1^\dagger\Gamma_1 + it_2 f_2^\dagger\Gamma_2 + t_3 f_1^\dagger\Gamma_3 + it_4 f_2^\dagger\Gamma_4 + h.c.\Big) \\ &\times\sum_{i',j'}|i'\rangle\langle i'|\otimes|j'\rangle\langle j'|_{QD} \\ = &-\frac{t_1}{2}\left(|2\rangle\langle 0| + |0\rangle\langle 1|\right)\otimes\left(|1\rangle\langle 0| + |3\rangle\langle 2|\right)_{QD} \\ &- p_1\frac{t_2}{2}\left(|2\rangle\langle 0| - |0\rangle\langle 1|\right)\otimes\left(|2\rangle\langle 0| - |3\rangle\langle 1|\right)_{QD} \\ &-\frac{t_3}{2}\left(|4\rangle\langle 0| + |0\rangle\langle 3|\right)\otimes\left(|1\rangle\langle 0| + |3\rangle\langle 2|\right)_{QD} \\ &- p_2\frac{t_4}{2}\left(|4\rangle\langle 0| - |0\rangle\langle 3|\right)\otimes\left(|2\rangle\langle 0| - |3\rangle\langle 1|\right)_{QD} + h.c. \end{aligned} \tag{29}$$

In the above basis, the quantum dot Hamiltonian can be written as

$$H_{\text{dots}} = \mathbb{1}\otimes\sum_i E_{\text{dots},i}\,|i\rangle\langle i|_{QD} \tag{30}$$

while the superconducting island Hamiltonian is

$$H_0 = \sum_i E_i\,|i\rangle\langle i|\otimes\mathbb{1}_{QD}. \tag{31}$$

To be explicit,

$$E_0 = E_{C,1}\left(Q_1 - Q_{0,1}\right)^2 + E_{C,2}\left(Q_2 - Q_{0,2}\right)^2$$

$$E_1 = E_{C,1}\left(Q_1 + 1 - Q_{0,1}\right)^2 + E_{C,2}\left(Q_2 - Q_{0,2}\right)^2$$

$$E_2 = E_{C,1}\left(Q_1 - 1 - Q_{0,1}\right)^2 + E_{C,2}\left(Q_2 - Q_{0,2}\right)^2$$

$$E_3 = E_{C,1}\left(Q_1 - Q_{0,1}\right)^2 + E_{C,2}\left(Q_2 + 1 - Q_{0,2}\right)^2$$

$$E_4 = E_{C,1}\left(Q_1 - Q_{0,1}\right)^2 + E_{C,2}\left(Q_2 - 1 - Q_{0,2}\right)^2 \quad (32)$$

$$E_{\text{dots},0} = \epsilon_1 \delta_{\text{dot},1}^2 + \epsilon_2 \delta_{\text{dot},2}^2$$

$$E_{\text{dots},1} = \epsilon_1 \left(1 - \delta_{\text{dot},1}\right)^2 + \epsilon_2 \delta_{\text{dot},2}^2$$

$$E_{\text{dots},2} = \epsilon_1 \delta_{\text{dot},1}^2 + \epsilon_2 \left(1 - \delta_{\text{dot},2}\right)^2$$

$$E_{\text{dots},3} = \epsilon_1 \left(1 - \delta_{\text{dot},1}\right)^2 + \epsilon_2 \left(1 - \delta_{\text{dot},2}\right)^2 .$$

In this basis, the total Hamiltonian,

$$H_{\text{tot}} = H_{\text{tunn}}^{\text{eff}} + H_{\text{dots}} + H_0, \quad (33)$$

is a 20×20 Hermitian matrix that can be numerically diagonalized. In the next section, the results of the numerical diagonalization are discussed.

**C. Energy shift dependence on joint parity P**

***1. Symmetric limit***

First, one can solve for the eigenvalues of Eq. (33) in the symmetric limit where the superconducting islands have equal charging energies, $E_{C,1} = E_{C,2} = E_C$, the tunnel couplings on the left (right) dots are the same, $t_1 = t_3 = t_L$ and $t_2 = t_4 = t_R$, the dots are tuned to the degeneracy point $\delta_{\text{dot},i} = 1/2$, and the offset charge on the islands has been tuned so that $Q_1 = Q_{0,1}$ and $Q_2 = Q_{0,2}$. The last assumption implies that $E_{i\neq 0} = E_C$ and $E_0 = 0$.

The four lowest eigenenergies of the full system are slightly shifted from zero due to the coupling between the quantum dots and the Majorana nanowires:

$$\varepsilon_0 = \varepsilon_1 = \frac{E_C}{2}\left(1 - \sqrt{1 + \frac{2}{E_C^2}\left(|t_L|^2 + 2|t_R|^2\right)}\right)$$

$$\varepsilon_2 = \frac{E_C}{2}\left(1 - \sqrt{1 + \frac{2}{E_C^2}\left(|t_L|^2 + |t_R|^2 + (1+p)\,|t_L||t_R|\right)}\right) \quad (34)$$

$$\varepsilon_3 = \frac{E_C}{2}\left(1 - \sqrt{1 + \frac{2}{E_C^2}\left(|t_L|^2 + |t_R|^2 - (1+p)\,|t_L||t_R|\right)}\right) .$$

One may notice that the only parity dependence is on the product $p = p_1 p_2$. Thus, the measurement of the QD energy shift constitutes a joint parity measurement. However, this measurement does not allow one to determine the parity state of the individual wire #1 or wire #2. The lowest eigenvalues are consistent with the results presented above.

In the limit of weak tunneling (i.e. $\frac{|t_{L/R}|}{E_C} \ll 1$), the leading order of perturbation theory yields

$$\begin{aligned} \varepsilon_0 = \varepsilon_1 &\approx -\frac{|t_L|^2 + |t_R|^2}{2E_C} \\ \varepsilon_2 &\approx -\frac{|t_L|^2 + |t_R|^2 + (1+p)\,|t_L||t_R|}{2E_C} \\ \varepsilon_3 &\approx -\frac{|t_L|^2 + |t_R|^2 - (1+p)\,|t_L||t_R|}{2E_C} \end{aligned} \tag{35}$$

To lowest order in $|t_{L/R}|/E_C$, when the parities are opposite ($p$ = -1) there are four degenerate ground state energies. When the parities are equal ($p$ = +1) the degeneracy is split into three energy levels, one of which is degenerate. These degeneracies, however, are accidental and are due to the choice of parameters made. Once one considers the most general theory with different $t_j$ and $E_{Cj}$ the degeneracies will be lifted. In any case, the conclusion is that it is possible to determine from the low energy spectrum whether the combined parity, $p$, is even or odd. This difference in energy can be detected using the standard energy-level spectroscopy techniques (e.g. probing DoS in the QD).

In the discussion above, the focus has been on the specific point when $Q_{1/2} = Q_{0,1/2}$. This section will now investigate the spectrum away from this point and demonstrate that effect still persists (the energy of the full system still depends on the combined parity $p$). Let's define the detuning from this point as $Q_{1/2} = Q_{0,1/2} - \delta$, where $1 \gg \delta > 0$. The energies of $H_0$ are now give by

$$\begin{aligned} E_0 &= E_C\delta^2, \\ E_1 = E_3 &= E_C(1-\delta)^2, \\ E_2 = E_4 &= E_C(1+\delta)^2. \end{aligned} \tag{36}$$

The analytical expression is not illuminating so we present numerical results instead. The plots of the four lowest eigenenergies vs $\delta$ are shown in FIGS. 18 and 19.

FIG. 18 is a graph 1800 showing the dependence of the four lowest energy eigenvalues (measured in units of $t$) vs. $\delta$ for the **even** parity ground state degeneracy splitting. Here $E_C$ = 100, $t_L$ = 1, $t_R$ = i, and $p$ = +1 (even parity). Note that at the degenerate point considered in the previous section, there are three distinct energies with the middle curve nearly two-fold degenerate (analogous to $\varepsilon_{0/1}$ in the previous section).

FIG. 19 is a graph 1900 showing the dependence of the four lowest energy eigenvalues (measured in units of $t$) vs. $\delta$ for the **odd** parity degenerate ground states. Here the parameters are the same as in FIG. 18, but with $p$ = -1 (odd parity). Notice that all four energies are nearly degenerate.

*2. Quantum Dot gate voltage dependence of the energy shift*

In addition to energy-level spectroscopy, it will now be demonstrated that quantum capacitance of the system depends on the joint parity $p$. Consider the case when QD1, for example, is capacitively coupled to an LC resonator. The impedance of the system depends on the capacitance of the QD which is sensitive to quantum charge fluctuations in the dot. Quantum capacitance of the system is defined as the curvature of the energy with respect to the offset charge on the dot.

$$C_Q^{-1} = \frac{1}{e^2}\frac{\partial^2 E_{\mathrm{GS}}}{\partial^2 \delta_{\mathrm{dot}}}, \tag{37}$$

where $E_{GS}$ is the ground-state energy of the system. The plots of the energy dependence on $\delta_{\mathrm{dot},1}$ for different parities are shown in FIGS. 20 and 21. As a measure of the QD capacitance change, consider the relative difference $\nu$, defined as

$$\nu_Q = \frac{C_Q(p=+1) - C_Q(p=-1)}{C_Q(p=+1) + C_Q(p=-1)} \quad (38)$$

and plot it as a function of $t_R = t_L = t$, see FIG. 22. Note that this method works for parameter regime when the ground-state energy is parity-dependent.

More specifically, FIG. 20 is a graph 2000 showing the lowest eigenvalues as a function of the gate charge offset $\delta_{dot}$ for **even** joint parity. Here, the following parameters were used $\varepsilon_1 = \varepsilon_2 = 0.05$, $t_L = 1$, $t_R = l$, $E_C = 100$, $\delta = 0$, $p = +1$. FIG. 21 is a graph 2100 showing the lowest eigenvalues as a function of the gate charge offset $\delta_{dot}$ for odd joint parity. Here, the following parameters were used $\varepsilon_1 = \varepsilon_2 = 0.05$, $t_L = 1$, $t_R = l$, $E_C = 100$, $\delta = 0$, $p = -1$. FIG. 22 is a graph 2200 showing the relative difference in quantum capacitances $\nu_Q$ for even and odd joint parity states as a function of $t$. Here we used the following parameters: $\varepsilon_1 = \varepsilon_2 = 500$, $t_L = 10$, $t_R = 10l$, $E_C = 100$, $\delta = 0$ and $\delta_{dot,1/2} = 0.5$.

The disclosed technology can be used as a basic building block for a Majorana-based quantum computer that is protected from quasiparticle errors (e.g., quasiparticle poisoning) by the charging energy of the superconducting islands (e.g., $E_{Cj}$). Further, gate voltages $V_gj$ allow one to control the charge on the superconducting islands. Described herein, are methods for measuring joint parity $P$ of four Majorana zero modes ($P = \gamma_1\gamma_2\gamma_3\gamma_4$) using quantum dots (the quantum dot energy shift depends on the product of $\gamma_1\gamma_2\gamma_3\gamma_4$). Further, tunnel couplings $t_j$ are gate-tunable and, in certain embodiments, can be turned on or off on demand. Tunnel couplings $t_j$ and quantum dot gate voltages $V_Dj$ are used to decouple QDs from the topological qubit. This allows one to generate XX, ZZ, ZX and XZ spin couplings between the qubits.

As discussed and explained above, FIG. 17 is a schematic layout 1700 of an example device for joint parity measurement. The layout 1700 can be used to generate ZZ couplings. In the layout 1700, by measuring the energy shift in the dot, one can perform a measurement of the joint fermion parity $\gamma_1\gamma_2\gamma_3\gamma_4$. Using the following encoding for fermion parities $p_1 = i\gamma_1\gamma_2$, $p_{1'} = i\gamma_{1'}\gamma_{2'}$, $p_2 = i\gamma_3\gamma_4$, and $p_{2'} = i\gamma_{3'}\gamma_{4'}$, the aforementioned measurement is equivalent to $Z_1Z_2$ spin coupling.

FIG. 23 is a schematic layout 2300 of an example device for joint parity measurement. The layout 2300 can be used to generate XX couplings. In the layout 2300, superconducting islands 2311 and 2312 are characterized by the corresponding charging energies $E_{Cj} = (e^2)/(2C_{\Sigma j})$ with $C_{\Sigma j}$ being the geometric capacitance of the J-th island. Further, each island contains 4 Majorana zero modes (shown as circles, such as circles 2321, 2322). Quantum dots (QD1 and QD2) are assumed to have large charging energy as well. The charge on the islands and dots can be controlled via capacitively coupled gate electrodes. By measuring the energy shift in the dot, one can perform the measurement of the joint fermion parity $\gamma_1\gamma_2\gamma_3\gamma_4$. Using the following encoding for fermion parities $p_j = i\gamma_j\gamma_{j'}$ for $j = 1..4$ (which defines the z-basis for qubits), the aforementioned measurement is equivalent to $X_1X_2$ spin coupling.

FIG. 24 is a schematic layout 2400 of an example device for joint parity measurement. The layout 2400 can be used to generate ZX couplings. By measuring the energy shift in the dot, one performs a measurement of the joint fermion parity $\gamma_1\gamma_2\gamma_3\gamma_4$. Using the following encoding for fermion parities $p_1 = i\gamma_1\gamma_2$, $p_{1'} = i\gamma_{1'}\gamma_{2'}$, $p_2 = i\gamma_3\gamma_4$, and $p_{2'} = i\gamma_{3'}\gamma_{4'}$, the aforementioned measurement is equivalent to $Z_1X_2$ spin coupling. Using a scheme, one can also generate $X_1Z_2$ spin coupling.

FIG. 25 is a flowchart 2500 for operating a quantum system.

At 2510, gate voltages at a set of gates are altered to create tunnel couplings between one or more quantum dots and two or more Majorana zero modes, the tunnel couplings altering energy levels of the one or more quantum dots, resulting in a hybridization of quantum states in the quantum system.

At 2512, a hybridization energy of the quantum system is measured.

At 2514, a joint parity of the two or more Majorana zero modes is determined based on the measured hybridization.

The method can further comprise altering the gate voltages at the set of gates to decouple the one or more quantum dots from the two or more Majorana zero modes. The can further comprise measuring respective charges of the one or more quantum dots.

The method further comprises using the joint parity to implement the full set of Clifford gates in a quantum computer. Still further, the two or more Majorana zero modes are part of a phase gate in a quantum computer.

In some implementations, the measuring is performed using spectroscopy. In certain implementations, the measuring is performed using a microwave resonator. In further implementations, the measuring is performed by measuring quantum capacitance.

FIG. 26 is a flowchart 2600 for operating a quantum system.

At 2610, a collective topological charge of a plurality of non-Abelian quasiparticles using quantum dots is measured. In particular implementations, the non-Abelian quasiparticles are Majorana zero modes. Further, the measuring can comprise measuring a joint parity P of the Majorana zero modes using the quantum dots, the joint parity being the product of the topological charge of the plurality of the Majorana zero modes.

At 2612, the measurement of the topological charge is used to implement the full set of Clifford gates in a quantum computer.

In some implementations, a first and a second of the Majorana zero modes are implemented on a first superconducting island, and a third and a fourth of the Majorana zero modes are implemented on a second superconducting island separate from the first superconducting island. Further, in certain implementations, the measuring is performed using spectroscopy. In some implementations, the measuring is performed using a microwave resonator. In further implementations, the measuring is performed by measuring quantum capacitance.

XI. CONCLUDING REMARKS

Other architectures with which the disclosed technology can be used, are described in T. Karzig et al., "Scalable Designs for Quasiparticle-Poisoning-Protected Topological Quantum Computation with Majorana Zero Modes," arXiv: 1610.05289 (March 2017) and T. Karzig et al., "Scalable Designs for Quasiparticle-Poisoning-Protected Topological Quantum Computation with Majorana Zero Modes," Phys. Rev. B 95, 235305 (2017).

## Claims

**1.** A two-sided Majorana Hexon qubit (100), comprising:

three one-dimensional topological superconductors (110), each of the one-dimensional topological superconductors (110) having a respective first end at which a respective first Majorana zero mode resides and a respective second end, opposite the respective first end, where a respective second Majorana zero mode resides, such that the two-sided Majorana Hexon qubit comprises six Majorana zero modes, and wherein four of the six Majorana zero modes of the two-sided Majorana Hexon qubit encode a computational qubit, and the Majorana zero modes further comprise an ancillary pair of Majorana zero modes; and
a superconducting backbone element (112) connected to the three one-dimensional topological superconductors (110), the superconducting backbone element (112) being located between the respective first ends and the respective second ends of the three one-dimensional topological superconductors.

**2.** The two-sided Majorana Hexon qubit (100) of claim 1, wherein the three one-dimensional topological superconductors are located on a superconducting island having a charging energy sufficient to prevent quasiparticle poisoning.

**3.** The two-sided Majorana Hexon qubit (100) of claim 1, wherein the superconducting backbone element is oriented transverse to the three one-dimensional topological superconductors.

**4.** The two-sided Majorana Hexon qubit (100) of claim 1,

wherein the three one-dimensional topological superconductors are half-shell topological wires or p-wave superconductors, and
wherein the superconducting backbone element is an s-wave superconductor.

**5.** The two-sided Majorana Hexon qubit (100) of claim 1, further comprising a fourth one-dimensional topological superconductor selectively coupled to the respective first ends of the three one-dimensional topological superconductors and having a second end selectively coupled to the respective second ends of the three one-dimensional topological superconductors,

wherein the first end of the fourth one-dimensional topological superconductor is selectively coupled to the respective first ends of the three one-dimensional topological superconductors via a first-end semiconductive wire, and
wherein the second end of the fourth one-dimensional topological superconductor is selectively coupled to the respective second ends of the three one-dimensional topological superconductors via a second-end semiconductive wire.

**6.** The two-sided Majorana Hexon qubit (100) of claim 5, further comprising:

a set of first-end depletion gates arranged to provide selective quantum-dot couplings between the fourth one-dimensional topological superconductor and any one or more of the first ends of the three one-dimensional topological superconductors via the first-end semiconductive wire; and
a set of second-end depletion gates arranged to provide selective quantum-dot couplings between the fourth one-dimensional topological superconductor and any one or more of the second ends of the three one-dimensional topological superconductors via the second-end semiconductive wire.

**7.** A network comprising multiple instances of the two-sided Majorana Hexon qubit (100) of claim 5 or claim 6, wherein at least one of the first-end semiconductive wire or the second-end semiconductive wire is shared with one or more neighboring instances of the two-sided Majorana Hexon qubit, and wherein the one or more neighboring instances of the two-sided Maj orana Hexon qubit are neighboring along a horizontal direction, a vertical direction, or both.

**8.** A one-sided Majorana Hexon qubit (400), comprising:

six one-dimensional topological superconductors (410), each of the one-dimensional topological superconductors having a respective Majorana-zero-mode (MZM) end at which a respective first MZM resides, and a respective backbone end opposite the MZM end, such that the one-sided Majorana Hexon qubit comprises six Majorana zero modes, and wherein four of the six Majorana zero modes of the one-sided Majorana Hexon qubit encode a computational qubit, and the Majorana zero modes further comprise an ancillary pair of Majorana zero modes; and
a superconducting backbone element (412) connected to the six one-dimensional topological superconductors, the superconducting backbone element being connected to the six one-dimensional topological superconductors at the respective backbone ends of the six one-dimensional topological superconductors.

**9.** The one-sided Majorana Hexon qubit of claim 8, wherein the six one-dimensional topological superconductors are located on a superconducting island having a charging energy sufficient to prevent quasiparticle poisoning.

**10.** The one-sided Majorana Hexon qubit of claim 8, wherein the superconducting backbone element is oriented transverse to the six one-dimensional topological superconductors.

**11.** The one-sided Maj orana Hexon qubit of claim 8,

wherein the six one-dimensional topological superconductors are topological superconducting nanowires that are half-shell topological wires or p-wave superconductors, and
wherein the superconducting backbone element is an s-wave superconductor.

**12.** A network comprising multiple instances of the one-sided Majorana Hexon qubit (500) of claim 8, wherein a first instance and a second instance of the one-sided Majorana Hexon qubits are arranged such that their respective superconducting backbone elements (512) face one another and their respective six MZM ends are in opposite directions from one another,

wherein the network further comprises a first reference-arm topological superconducting nanowire (514) having a first end selectively coupled to each of the respective MZM ends of the first instance of the one-sided Majorana Hexon qubit and having a second end selectively coupled to each of the respective MZM ends of the second instance of the one-sided Majorana hexon qubit, and
wherein the network further comprises a second reference-arm topological superconducting nanowire (514) having a first end selectively coupled to each of the respective MZM ends of the first instance of the one-sided Majorana Hexon qubit and having a second end selectively coupled to each of the respective MZM ends of the second instance of the one-sided Majorana Hexon qubit,
the second reference-arm topological superconducting nanowire being located on an opposite side of the first instance and the second instance of the one-side Majorana Hexon qubit than the first reference-arm topological superconducting nanowire.

**13.** The network of claim 12,

wherein the first end of the first reference-arm topological superconducting nanowire is selectively coupled to each of the respective MZM ends of the first instance of the one-sided Majorana Hexon qubit via a first-end semiconductive wire,
wherein the second end of the first reference-arm topological superconducting nanowire is selectively coupled to each of the respective MZM ends of the second instance of the one-sided Majorana Hexon qubit via a second-end semiconductive wire, and

wherein the network further comprises: (a) a set of first-end depletion gates arranged to provide a selective quantum-dot coupling between the first end of the first reference-arm topological superconducting nanowire and any one or more of the MZM ends of the first instance of the one-sided Majorana Hexon qubit via the first-end semiconductive wire; and (b) a set of second-end depletion gates arranged to provide a selective quantum-dot coupling between the second end of the first reference-arm topological superconducting nanowire and any one or more of the MZM ends of the second instance of the one-sided Majorana Hexon qubit via the second-end semiconductive wire,

wherein at least one of the first-end semiconductive wire or the second-end semiconductive wire is shared with one or more neighboring instances of the one-sided Majorana Hexon qubit, and

wherein the one or more neighboring instances of the one-side Majorana Hexon qubit are neighboring along a horizontal direction, a vertical direction, or both.

**14.** A linear Majorana Hexon qubit, comprising:
a one-dimensional topological superconductor partitioned into regions, including:

three MZM topological superconducting regions (710), each having a respective first end at which a respective first Majorana zero mode resides, and a respective second end, opposite the respective first end, where a respective second Majorana zero mode resides, such that the linear Majorana Hexon qubit comprises six Majorana zero modes, and wherein four of the six Majorana zero modes of the linear Majorana Hexon qubit encode a computational qubit, and the Majorana zero modes further comprise an ancillary pair of Majorana zero modes; and

two s-wave superconducting regions (712) that separate the three MZM topological superconducting regions from one another.

**15.** The linear Majorana Hexon qubit of claim 14,

wherein the s-wave superconducting regions are created by gating junctions between the MZM topological superconducting regions and the s-wave superconducting regions, and

wherein the one-dimensional topological superconductor is located on a superconducting island having a charging energy sufficient to prevent quasiparticle poisoning.

**Patentansprüche**

**1.** Zweiseitiges Majorana-Hexon-Qubit (100), umfassend:

drei eindimensionale topologische Supraleiter (110), wobei jeder der eindimensionalen topologischen Supraleiter (110) ein jeweiliges erstes Ende aufweist, an dem sich ein jeweiliger erster Majorana-Nullmodus befindet, und ein jeweiliges zweites Ende, das dem jeweiligen ersten Ende gegenüberliegt, an dem sich ein jeweiliger zweiter Majorana-Nullmodus befindet, sodass das zweiseitige Majorana-Hexon-Qubit sechs Majorana-Nullmoden umfasst, und wobei vier der sechs Majorana-Nullmoden des zweiseitigen Majorana-Hexon-Qubits ein Rechen-Qubit codieren, und die Majorana-Nullmoden weiter ein zusätzliches Paar von Majorana-Nullmoden umfassen; und

ein supraleitendes Backbone-Element (112), das mit den drei eindimensionalen topologischen Supraleitern (110) verbunden ist, wobei das supraleitende Backbone-Element (112) sich zwischen den jeweiligen ersten Enden und den jeweiligen zweiten Enden der drei eindimensionalen topologischen Supraleiter befindet.

**2.** Zweiseitiges Majorana-Hexon-Qubit (100) nach Anspruch 1, wobei sich die drei eindimensionalen topologischen Supraleiter auf einer supraleitenden Insel befinden, deren Ladungsenergie ausreicht, um eine Quasiteilchenvergiftung zu verhindern.

**3.** Zweiseitiges Majorana-Hexon-Qubit (100) nach Anspruch 1, wobei das supraleitende Backbone-Element quer zu den drei eindimensionalen topologischen Supraleitern ausgerichtet ist.

**4.** Zweiseitiges Majorana-Hexon-Qubit (100) nach Anspruch 1,

wobei die drei eindimensionalen topologischen Supraleiter topologische Halbschalendrähte oder p-Wellen-Supraleiter sind, und
wobei das supraleitende Backbone-Element ein s-Wellen-Supraleiter ist.

**5.** Zweiseitiges Majorana-Hexon-Qubit (100) nach Anspruch 1, das weiter einen vierten eindimensionalen topologischen Supraleiter umfasst, der selektiv mit den jeweiligen ersten Enden der drei eindimensionalen topologischen Supraleiter gekoppelt ist und ein zweites Ende aufweist, das selektiv mit den jeweiligen zweiten Enden der drei eindimensionalen topologischen Supraleiter gekoppelt ist,

wobei das erste Ende des vierten eindimensionalen topologischen Supraleiters selektiv mit den jeweiligen ersten Enden der drei eindimensionalen topologischen Supraleiter über einen Halbleiterdraht am ersten Ende gekoppelt ist, und
wobei das zweite Ende des vierten eindimensionalen topologischen Supraleiters selektiv mit den jeweiligen zweiten Enden der drei eindimensionalen topologischen Supraleiter über einen Halbleiterdraht am zweiten Ende gekoppelt ist.

**6.** Zweiseitiges Majorana-Hexon-Qubit (100) nach Anspruch 5, weiter umfassend:

einen Satz von Verarmungsgates am ersten Ende, die dazu ausgelegt sind, selektive Quantenpunkt-Kopplungen zwischen dem vierten eindimensionalen topologischen Supraleiter und einem oder mehreren der ersten Enden der drei eindimensionalen topologischen Supraleiter über den Halbleiterdraht am ersten Ende bereitzustellen; und
einen Satz von Verarmungsgates am zweiten Ende, die dazu ausgelegt sind, selektive Quantenpunkt-Kopplungen zwischen dem vierten eindimensionalen topologischen Supraleiter und einem oder mehreren der zweiten Enden der drei eindimensionalen topologischen Supraleiter über den Halbleiterdraht am zweiten Ende bereitzustellen.

**7.** Netzwerk, das mehrere Instanzen des zweiseitigen Majorana-Hexon-Qubits (100) nach Anspruch 5 oder Anspruch 6 umfasst, wobei mindestens einer der Halbleiterdrähte am ersten Ende oder der Halbleiterdraht am zweiten Ende mit einer oder mehreren benachbarten Instanzen des zweiseitigen Majorana-Hexon-Qubits gemeinsam genutzt wird und wobei die eine oder mehreren benachbarten Instanzen des zweiseitigen Majorana-Hexon-Qubits entlang einer horizontalen Richtung, einer vertikalen Richtung oder beiden benachbart sind.

**8.** Einseitiges Majorana-Hexon-Qubit (400), umfassend:

sechs eindimensionale topologische Supraleiter (410), wobei jeder der eindimensionalen topologischen Supraleiter ein jeweiliges Majorana-Nullmoden- (MZM) -Ende, an dem sich ein jeweiliger erster MZM befindet, und ein jeweiliges Grundgerüst-Ende gegenüber dem MZM-Ende aufweist, sodass das einseitige Majorana-Hexon-Qubit sechs Majorana-Null-Moden umfasst, und wobei vier der sechs Majorana-Null-Moden des einseitigen Majorana-Hexon-Qubits ein Rechen-Qubit codieren und die Majorana-Null-Moden weiter ein zusätzliches Paar von Majorana-Null-Moden umfassen; und
ein supraleitendes Backbone-Element (412), das mit den sechs eindimensionalen topologischen Supraleitern verbunden ist, wobei das supraleitende Backbone-Element mit den sechs eindimensionalen topologischen Supraleitern an den jeweiligen Grundgerüstenden der sechs eindimensionalen topologischen Supraleiter verbunden ist.

**9.** Einseitiges Majorana-Hexon-Qubit nach Anspruch 8, wobei sich die sechs eindimensionalen topologischen Supraleiter auf einer supraleitenden Insel befinden, deren Ladungsenergie ausreicht, um eine Quasiteilchenvergiftung zu verhindern.

**10.** Einseitiges Majorana-Hexon-Qubit nach Anspruch 8, wobei das supraleitende Backbone-Element quer zu den sechs eindimensionalen topologischen Supraleitern ausgerichtet ist.

**11.** Einseitiges Majorana-Hexon-Qubit nach Anspruch 8,

wobei es sich bei den sechs eindimensionalen topologischen Supraleitern um topologische supraleitende Nanodrähte handelt, die topologische Halbschalendrähte oder p-Wellen-Supraleiter sind, und
wobei das supraleitende Backbone-Element ein s-Wellen-Supraleiter ist.

**12.** Netzwerk, umfassend mehrere Instanzen des einseitigen Majorana-Hexon-Qubits (500) nach Anspruch 8, wobei eine erste Instanz und eine zweite Instanz der einseitigen Majorana-Hexon-Qubits so ausgelegt sind, dass ihre jeweiligen supraleitenden Backbone-Elemente (512) einander zugewandt sind und ihre jeweiligen sechs MZM-Enden in entgegengesetzten Richtungen zueinander liegen,

wobei das Netzwerk weiter einen ersten topologischen supraleitenden Referenzarm-Nanodraht (514) umfasst, der ein erstes Ende aufweist, das selektiv mit jedem der jeweiligen MZM-Enden der ersten Instanz des einseitigen Majorana-Hexon-Qubits gekoppelt ist, und ein zweites Ende aufweist, das selektiv mit jedem der jeweiligen MZM-Enden der zweiten Instanz des einseitigen Majorana-Hexon-Qubits gekoppelt ist, und
wobei das Netzwerk weiter einen zweiten topologischen supraleitenden Referenzarm-Nanodraht (514) umfasst, der ein erstes Ende aufweist, das selektiv mit jedem der jeweiligen MZM-Enden der ersten Instanz des einseitigen Majorana-Hexon-Qubits gekoppelt ist, und ein zweites Ende aufweist, das selektiv mit jedem der jeweiligen MZM-Enden der zweiten Instanz des einseitigen Majorana-Hexon-Qubits gekoppelt ist,
wobei sich der zweite topologische supraleitende Referenzarm-Nanodraht auf einer anderen Seite der ersten Instanz und der zweiten Instanz des einseitigen Majorana-Hexon-Qubits befindet als der erste topologische supraleitende Referenzarm-Nanodraht.

**13.** Netzwerk nach Anspruch 12,

wobei das erste Ende des ersten topologischen supraleitenden Referenzarm-Nanodrahtes selektiv mit jedem der jeweiligen MZM-Enden der ersten Instanz des einseitigen Majorana-Hexon-Qubits über einen Halbleiterdraht am ersten Ende gekoppelt ist,
wobei das zweite Ende des ersten topologischen supraleitenden Referenzarm-Nanodrahtes selektiv mit jedem der jeweiligen MZM-Enden der zweiten Instanz des einseitigen Majorana-Hexon-Qubits über einen Halbleiterdraht am zweiten Ende gekoppelt ist, und
wobei das Netzwerk weiter Folgendes umfasst: (a) einen Satz von Verarmungsgates am ersten Ende, die dazu ausgelegt sind, eine selektive Quantenpunktkopplung zwischen dem ersten Ende des ersten topologischen supraleitenden Referenzarm-Nanodrahtes und einem oder mehreren der MZM-Enden der ersten Instanz des einseitigen Majorana-Hexon-Qubits über den Halbleiterdraht am ersten Ende bereitzustellen; und (b) einen Satz von Verarmungsgates am zweiten Ende, die dazu ausgelegt sind, eine selektive Quantenpunktkopplung zwischen dem zweiten Ende des ersten topologischen supraleitenden Referenzarm-Nanodrahtes und einem oder mehreren der MZM-Enden der zweiten Instanz des einseitigen Majorana-Hexon-Qubits über den Halbleiterdraht am zweiten Ende bereitzustellen,
wobei mindestens einer der Halbleiterdrähte am ersten Ende oder der Halbleiterdraht am zweiten Ende mit einer oder mehreren benachbarten Instanzen des einseitigen Majorana-Hexon-Qubits gemeinsam genutzt wird, und
wobei die eine oder die mehreren benachbarten Instanzen des einseitigen Majorana-Hexon-Qubits entlang einer horizontalen Richtung, einer vertikalen Richtung oder beiden benachbart sind.

**14.** Lineares Majorana-Hexon-Qubit, umfassend:
ein eindimensionaler topologischer Supraleiter, der in Bereiche unterteilt ist, die Folgendes beinhalten:

drei topologisch supraleitende MZM-Bereiche (710), von denen jeder ein jeweiliges erstes Ende aufweist, an dem sich ein jeweiliger erster Majorana-Nullmodus befindet, und ein jeweiliges zweites Ende, das dem jeweiligen ersten Ende gegenüberliegt, an dem sich ein jeweiliger zweiter Majorana-Nullmodus befindet, sodass das lineare Majorana-Hexon-Qubit sechs Majorana-Nullmoden umfasst, und wobei vier der sechs Majorana-Nullmoden des linearen Majorana-Hexon-Qubits ein Rechen-Qubit codieren und die Majorana-Nullmoden weiter ein zusätzliches Paar von Majorana-Nullmoden umfassen; und
zwei s-Wellen-supraleitenden Bereiche (712), die die drei topologischen supraleitenden MZM-Bereiche voneinander trennen.

**15.** Lineares Majorana-Hexon-Qubit nach Anspruch 14,

wobei die s-Wellen-supraleitenden Bereiche durch Gateübergänge zwischen den topologischen supraleitenden MZM-Bereichen und den s-Wellen-supraleitenden Bereichen erzeugt werden, und
wobei sich der eindimensionale topologische Supraleiter auf einer supraleitenden Insel befindet, deren Ladeenergie ausreicht, um eine Quasiteilchenvergiftung zu verhindern.

## Revendications

**1.** Bit quantique de Majorana Hexon biface (100), comprenant :

trois supraconducteurs topologiques unidimensionnels (110), chacun des supraconducteurs topologiques unidimensionnels (110) présentant une première extrémité respective au niveau de laquelle réside un premier mode zéro de Majorana respectif et une seconde extrémité respective, opposée à la première extrémité respective, au niveau de laquelle réside un second mode zéro de Majorana respectif, de telle sorte que le bit quantique de Majorana Hexon biface comprend six modes zéro de Majorana, et dans lequel quatre des six modes zéro de Majorana du bit quantique de Majorana Hexon biface codent un bit quantique de calcul, et les modes zéro de Majorana comprennent en outre une paire auxiliaire de modes zéro de Majorana ; et
un élément de squelette supraconducteur (112) connecté aux trois supraconducteurs topologiques unidimensionnels (110), l'élément de squelette supraconducteur (112) étant situé entre les premières extrémités respectives et les secondes extrémités respectives des trois supraconducteurs topologiques unidimensionnels.

**2.** Bit quantique de Majorana Hexon biface (100) selon la revendication 1, dans lequel les trois supraconducteurs topologiques unidimensionnels sont situés sur un îlot supraconducteur présentant une énergie de charge suffisante pour empêcher un empoisonnement par des quasiparticules.

**3.** Bit quantique de Majorana Hexon biface (100) selon la revendication 1, dans lequel l'élément de squelette supraconducteur est orienté transversalement par rapport aux trois supraconducteurs topologiques unidimensionnels.

**4.** Bit quantique de Majorana Hexon biface (100) selon la revendication 1,

dans lequel les trois supraconducteurs topologiques unidimensionnels sont des fils topologiques demi-coquille ou des supraconducteurs à ondes p, et
dans lequel l'élément de squelette supraconducteur est un supraconducteur à ondes S.

**5.** Bit quantique de Majorana Hexon biface (100) selon la revendication 1, comprenant en outre un quatrième supraconducteur topologique unidimensionnel couplé sélectivement aux premières extrémités respectives des trois supraconducteurs topologiques unidimensionnels et présentant une seconde extrémité couplée sélectivement aux secondes extrémités respectives des trois supraconducteurs topologiques unidimensionnels,

dans lequel la première extrémité du quatrième supraconducteur topologique unidimensionnel est couplée sélectivement aux premières extrémités respectives des trois supraconducteurs topologiques unidimensionnels via un fil semi-conducteur de première extrémité, et
dans lequel la seconde extrémité du quatrième supraconducteur topologique unidimensionnel est couplée sélectivement aux secondes extrémités respectives des trois supraconducteurs topologiques unidimensionnels via un fil semi-conducteur de seconde extrémité.

**6.** Bit quantique de Majorana Hexon biface (100) selon la revendication 5, comprenant en outre :

un ensemble de portes de déplétion de première extrémité agencées pour fournir des couplages sélectifs de points quantiques entre le quatrième supraconducteur topologique unidimensionnel et une ou plusieurs quelconques des premières extrémités des trois supraconducteurs topologiques unidimensionnels via le fil semi-conducteur de première extrémité ; et
un ensemble de portes de déplétion de seconde extrémité agencées pour fournir des couplages sélectifs de points quantiques entre le quatrième supraconducteur topologique unidimensionnel et une ou plusieurs quelconques des secondes extrémités des trois supraconducteurs topologiques unidimensionnels via le fil semi-conducteur de seconde extrémité.

**7.** Réseau comprenant de multiples instances du bit quantique de Majorana Hexon biface (100) selon la revendication 5 ou la revendication 6, dans lequel au moins l'un du fil semi-conducteur de première extrémité ou du fil semi-conducteur de seconde extrémité est partagé avec une ou plusieurs instances voisines du bit quantique de Majorana Hexon biface, et dans lequel les une ou plusieurs instances voisines du bit quantique de Majorana Hexon biface sont voisines le long d'une direction horizontale, d'une direction verticale, ou des deux.

**8.** Bit quantique de Majorana Hexon monoface (400), comprenant :

six supraconducteurs topologiques unidimensionnels (410), chacun des supraconducteurs topologiques unidimensionnels présentant une extrémité respective de mode zéro de Majorana (MZM) au niveau de laquelle réside un premier MZM respectif, et une extrémité de squelette respective opposée à l'extrémité de MZM, de telle sorte que le bit quantique de Majorana Hexon monoface comprend six modes zéro de Majorana, et dans lequel quatre des six modes zéro de Majorana du bit quantique de Majorana Hexon monoface codent un bit quantique de calcul, et les modes zéro de Majorana comprennent en outre une paire auxiliaire de modes zéro de Majorana ; et

un élément de squelette supraconducteur (412) connecté aux six supraconducteurs topologiques unidimensionnels, l'élément de squelette supraconducteur étant connecté aux six supraconducteurs topologiques unidimensionnels au niveau des extrémités de squelette respectives des six supraconducteurs topologiques unidimensionnels.

**9.** Bit quantique de Majorana Hexon monoface selon la revendication 8, dans lequel les six supraconducteurs topologiques unidimensionnels sont situés sur un îlot supraconducteur présentant une énergie de charge suffisante pour empêcher un empoisonnement par des quasiparticules.

**10.** Bit quantique de Majorana Hexon monoface selon la revendication 8, dans lequel l'élément de squelette supraconducteur est orienté transversalement par rapport aux six supraconducteurs topologiques unidimensionnels.

**11.** Bit quantique de Majorana Hexon monoface selon la revendication 8,

dans lequel les six supraconducteurs topologiques unidimensionnels sont des nanofils supraconducteurs topologiques qui sont des fils topologiques en demi-coquille ou des supraconducteurs à ondes p, et

dans lequel l'élément de squelette supraconducteur est un supraconducteur à ondes S.

**12.** Réseau comprenant de multiples instances du bit quantique de Majorana Hexon monoface (500) selon la revendication 8, dans lequel une première instance et une seconde instance des bits quantiques de Majorana Hexon monofaces sont disposées de telle sorte que leurs éléments de squelette supraconducteurs respectifs (512) se font face mutuellement, et leurs six extrémités de MZM respectives sont dans des directions mutuellement opposées,

dans lequel le réseau comprend en outre un premier nanofil supraconducteur topologique à bras de référence (514) présentant une première extrémité couplée sélectivement à chacune des extrémités de MZM respectives de la première instance du bit quantique de Majorana Hexon monoface et présentant une seconde extrémité couplée sélectivement à chacune des extrémités de MZM respectives de la seconde instance du bit quantique de Majorana Hexon monoface, et

dans lequel le réseau comprend en outre un second nanofil supraconducteur topologique à bras de référence (514) présentant une première extrémité couplée sélectivement à chacune des extrémités de MZM respectives de la première instance du bit quantique de Majorana Hexon monoface et présentant une seconde extrémité couplée sélectivement à chacune des extrémités de MZM respectives de la seconde instance du bit quantique de Majorana Hexon monoface,

le second nanofil supraconducteur topologique à bras de référence étant situé sur un côté opposé de la première instance et de la seconde instance du bit quantique de Majorana Hexon monoface par rapport au premier nanofil supraconducteur topologique à bras de référence.

**13.** Réseau selon la revendication 12,

dans lequel la première extrémité du premier nanofil supraconducteur topologique à bras de référence est couplée sélectivement à chacune des extrémités de MZM respectives de la première instance du bit quantique de Majorana Hexon monoface via un fil semi-conducteur de première extrémité,

dans lequel la seconde extrémité du premier nanofil supraconducteur topologique à bras de référence est couplée sélectivement à chacune des extrémités de MZM respectives de la seconde instance du bit quantique de Majorana Hexon monoface via un fil semi-conducteur de seconde extrémité, et

dans lequel le réseau comprend en outre : (a) un ensemble de portes de déplétion de première extrémité agencées pour fournir un couplage sélectif de points quantiques entre la première extrémité du premier nanofil supraconducteur topologique à bras de référence et une ou plusieurs quelconques des extrémités de MZM de la première instance du bit quantique de Majorana Hexon monoface via le fil semi-conducteur de première extrémité ; et (b) un ensemble de portes de déplétion de seconde extrémité agencées pour fournir un couplage sélectif de points quantiques entre la seconde extrémité du premier nanofil supraconducteur topologique à bras de référence et une ou plusieurs quelconques des extrémités de MZM de la seconde instance du bit quantique de Majorana Hexon monoface via le fil semi-conducteur de seconde extrémité,
dans lequel au moins l'un du fil semi-conducteur de première extrémité ou du fil semi-conducteur de seconde extrémité est partagé avec une ou plusieurs instances voisines du bit quantique de Majorana Hexon monoface, et dans lequel les une ou plusieurs instances voisines du bit quantique de Majorana Hexon monoface sont voisines le long d'une direction horizontale, d'une direction verticale, ou des deux.

**14.** Bit quantique de Majorana Hexon linéaire, comprenant :
un supraconducteur topologique unidimensionnel divisé en régions, incluant :

trois régions supraconductrices topologiques de MZM (710), chacune présentant une première extrémité respective au niveau de laquelle réside un premier mode zéro de Majorana respectif, et une seconde extrémité respective, opposée à la première extrémité respective, au niveau de laquelle réside un second mode zéro de Majorana respectif, de telle sorte que le bit quantique de Majorana Hexon linéaire comprend six modes zéro de Majorana, et dans lequel quatre des six modes zéro de Majorana du bit quantique de Majorana Hexon linéaire codent un bit quantique de calcul, et les modes zéro de Majorana comprennent en outre une paire auxiliaire de modes zéro de Majorana ; et
deux régions supraconductrices à ondes S (712) qui séparent les trois régions supraconductrices topologiques de MZM les unes des autres.

**15.** Bit quantique de Majorana Hexon linéaire selon la revendication 14,

dans lequel les régions supraconductrices à ondes S sont créées par des jonctions de déclenchement entre les régions supraconductrices topologiques de MZM et les régions supraconductrices à ondes S, et
dans lequel le supraconducteur topologique unidimensionnel est situé sur un îlot supraconducteur présentant une énergie de charge suffisante pour empêcher un empoisonnement par des quasiparticules.

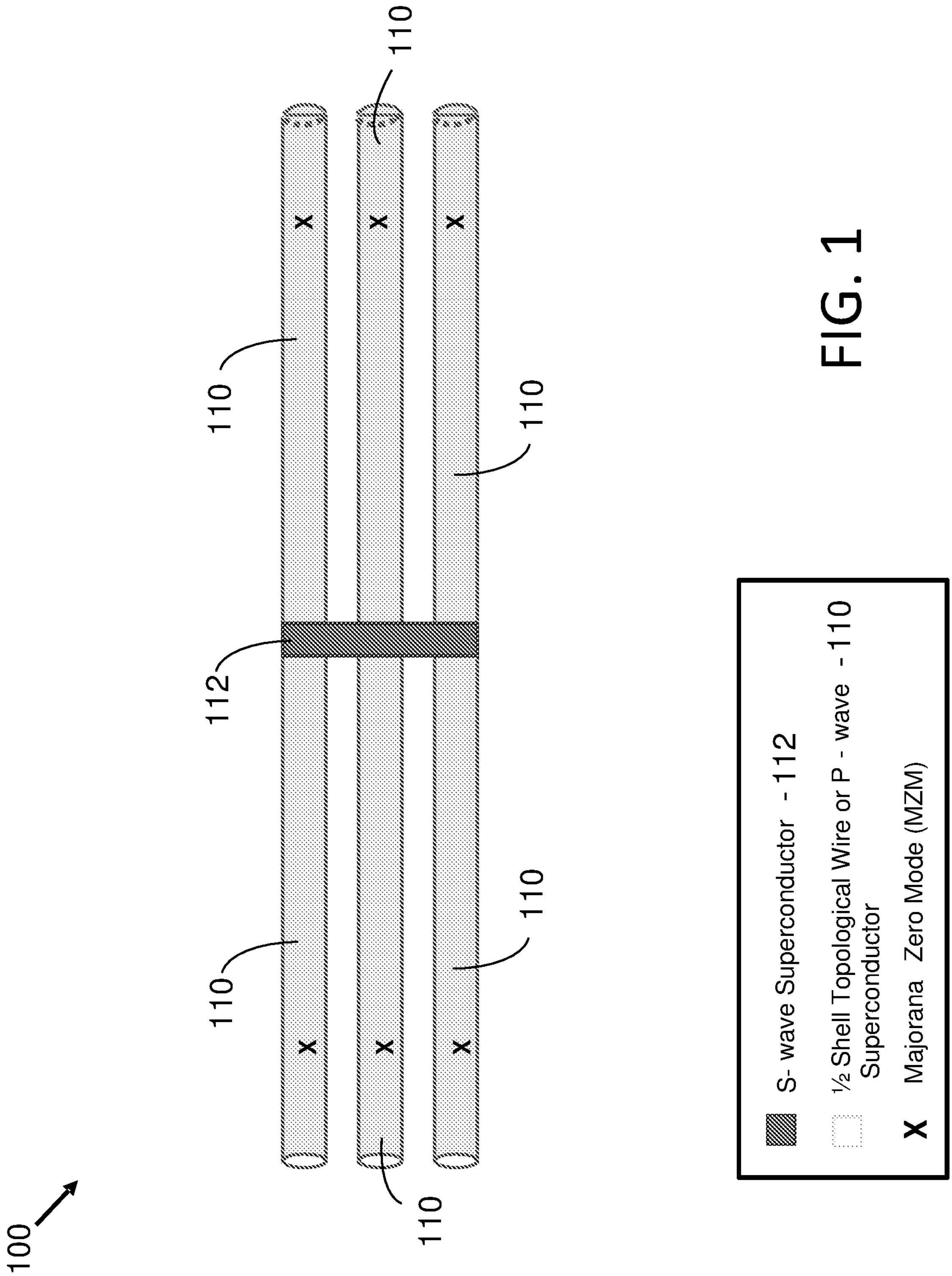
100
110
110
110
112
110
110
110
S- wave Superconductor - 112
½ Shell Topological Wire or P - wave Superconductor - 110
X Majorana Zero Mode (MZM)

FIG. 1

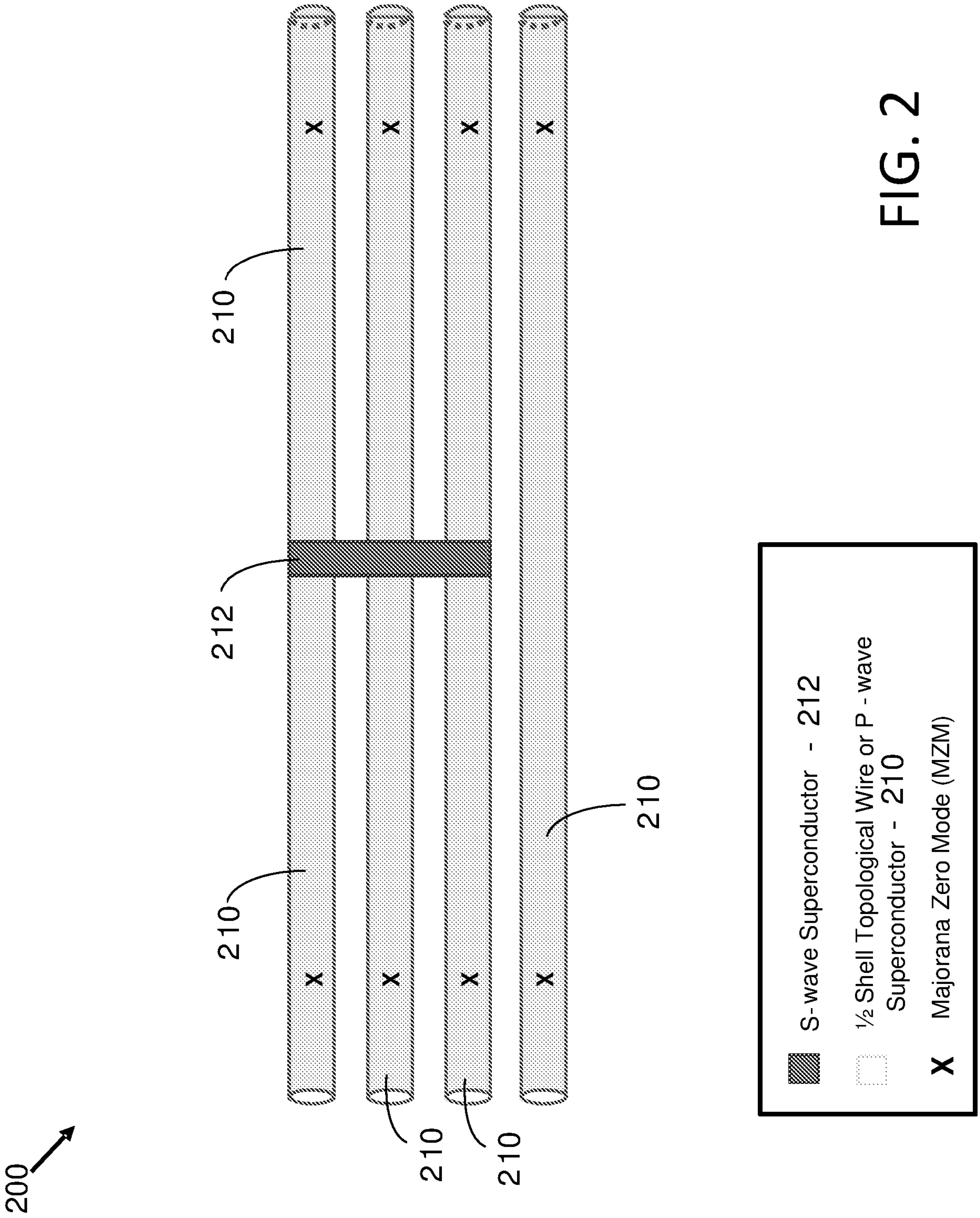
200
210
212
210
210
210
210
S-wave Superconductor - 212
½ Shell Topological Wire or P-wave Superconductor - 210
X Majorana Zero Mode (MZM)

FIG. 2

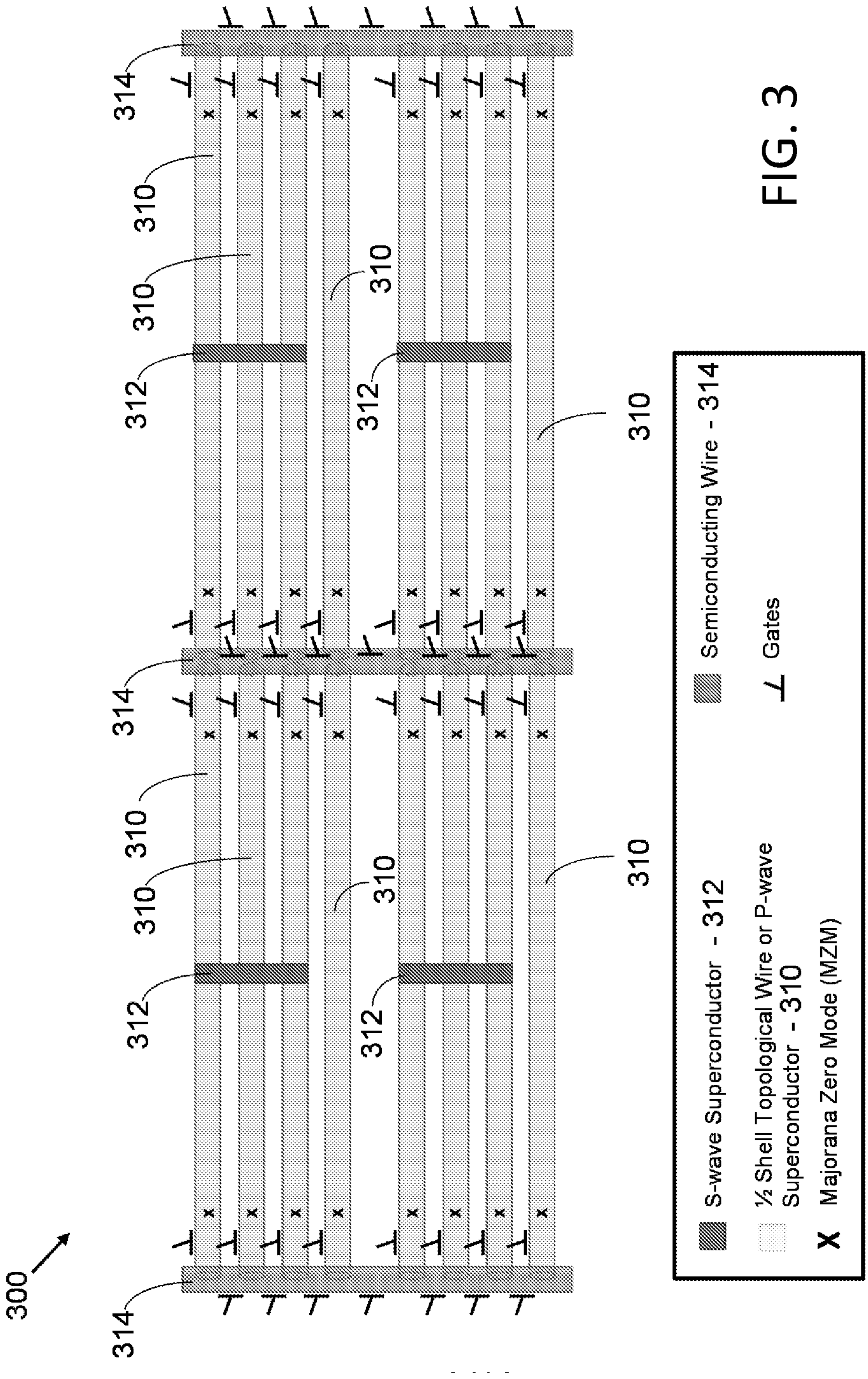
300
310
312
314
S-wave Superconductor - 312
½ Shell Topological Wire or P-wave Superconductor - 310
Majorana Zero Mode (MZM)
Semiconducting Wire - 314
Gates

FIG. 3

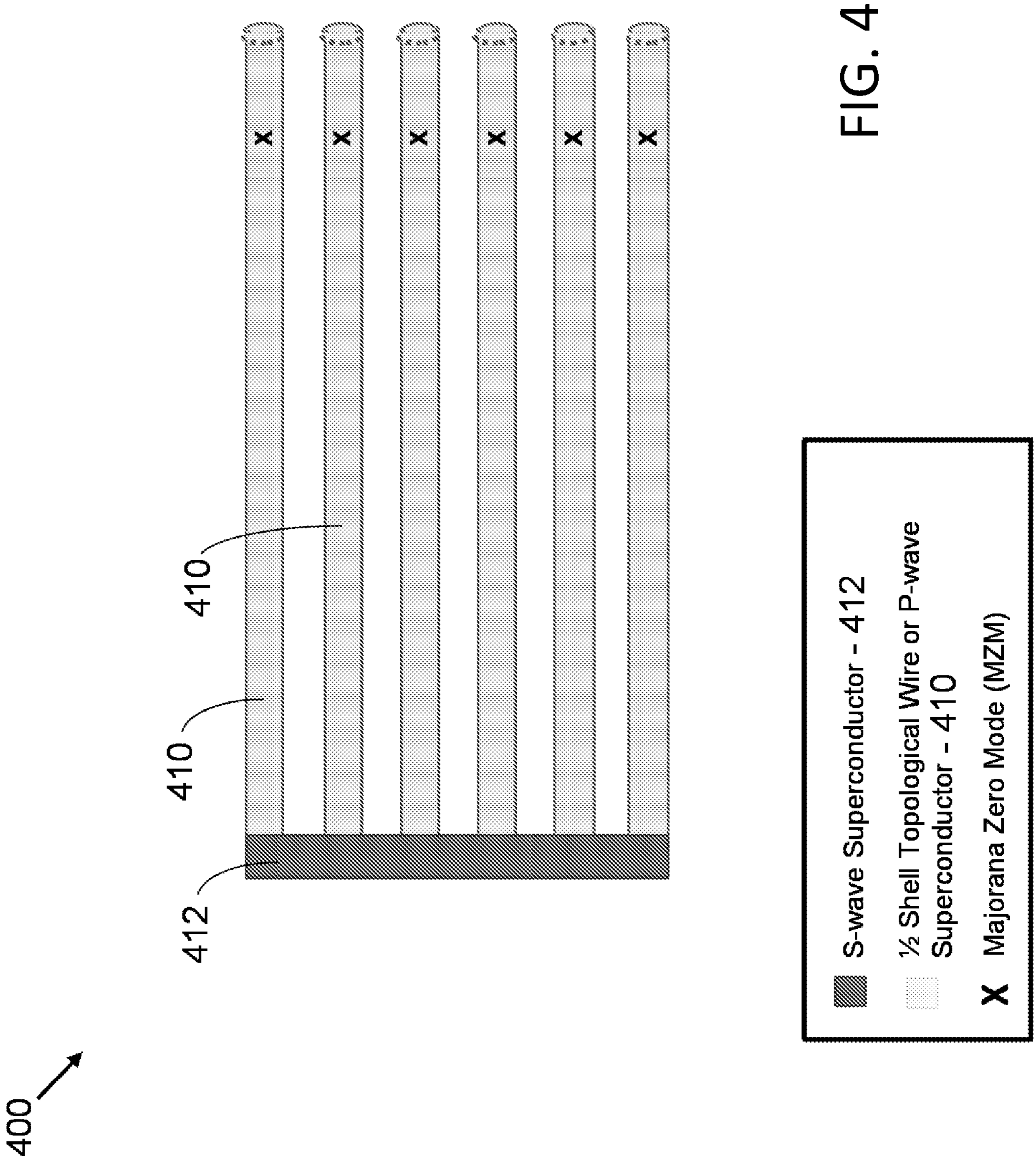
400
412
410
410
S-wave Superconductor - 412
½ Shell Topological Wire or P-wave Superconductor - 410
X Majorana Zero Mode (MZM)

FIG. 4

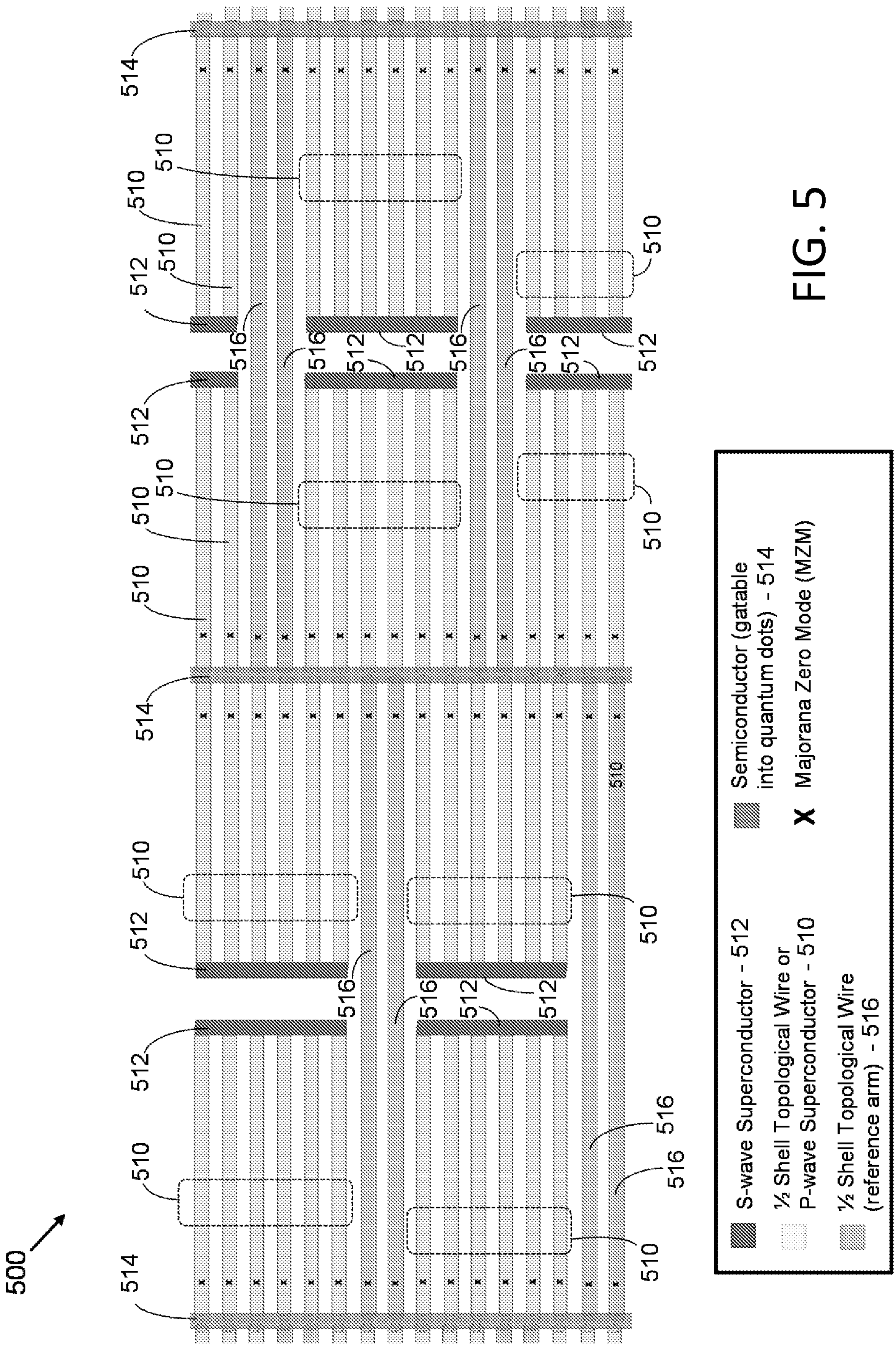
500
510
512
514
516
S-wave Superconductor - 512
½ Shell Topological Wire or P-wave Superconductor - 510
½ Shell Topological Wire (reference arm) - 516
Semiconductor (gatable into quantum dots) - 514
X Majorana Zero Mode (MZM)

FIG. 5

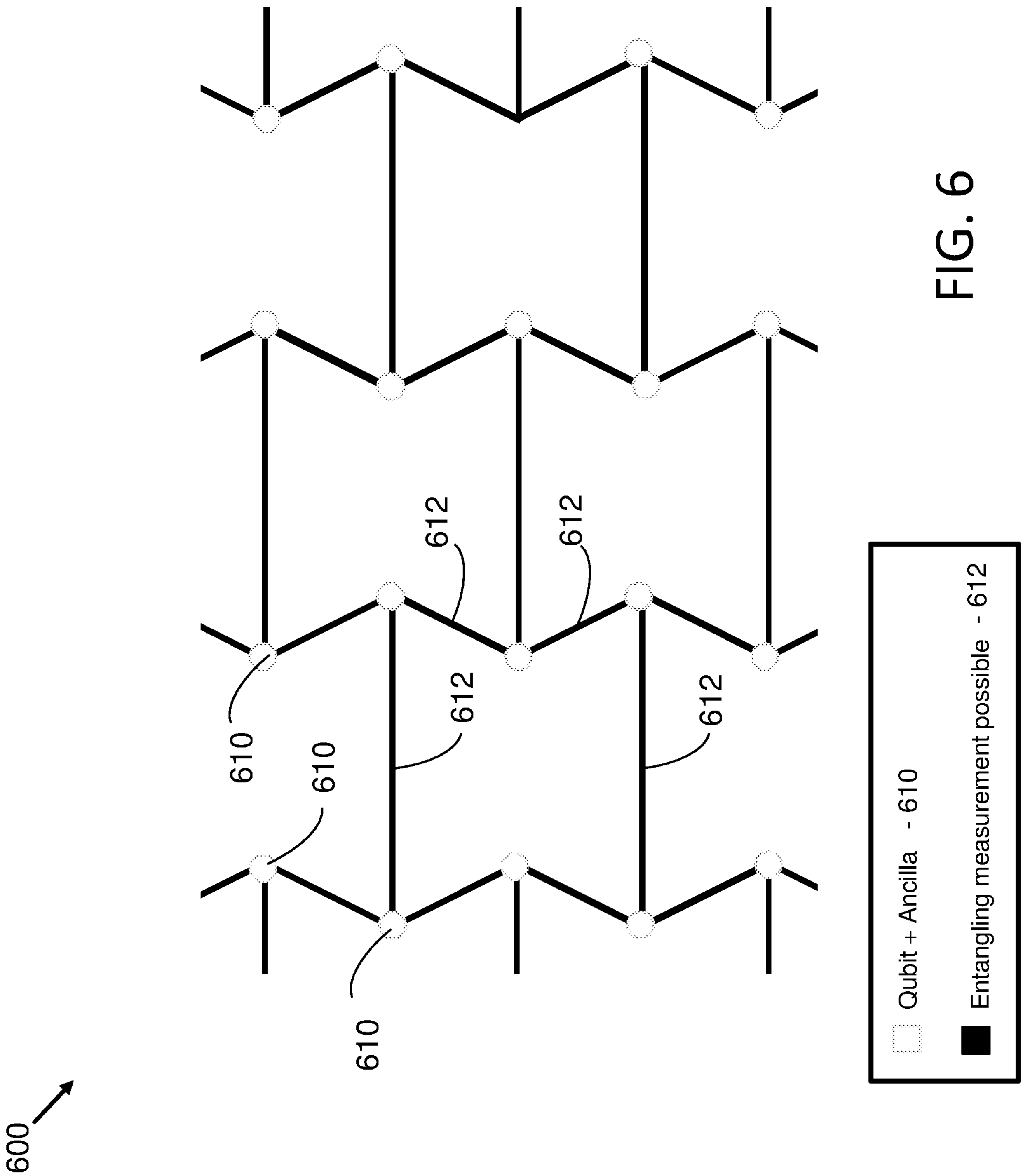
600
610
610
610
612
612
612
612
Qubit + Ancilla - 610
Entangling measurement possible - 612

FIG. 6

FIG. 7

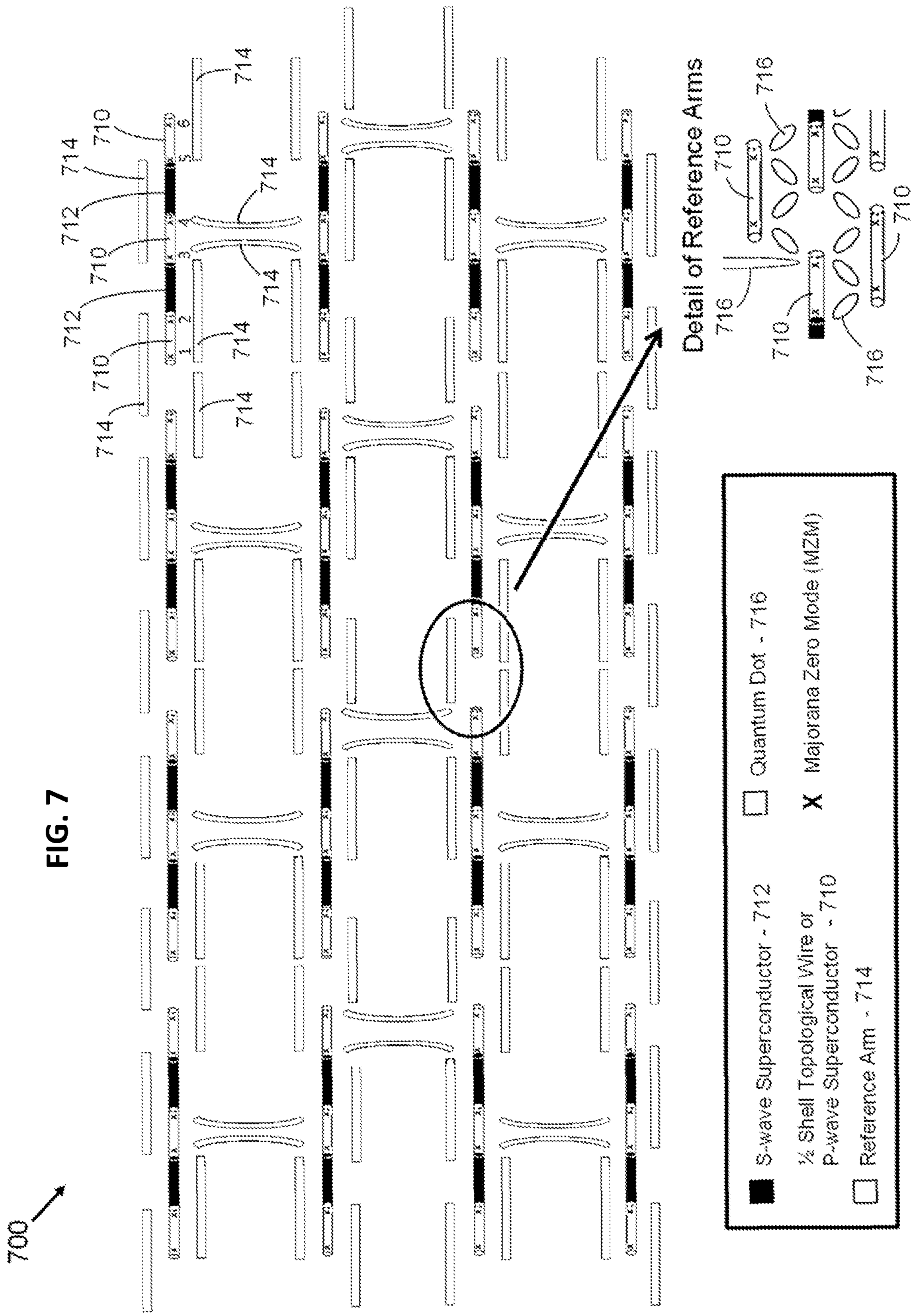
700
714
710
712
1
2
3
4
5
6
716
Detail of Reference Arms
S-wave Superconductor - 712
½ Shell Topological Wire or
P-wave Superconductor - 710
Reference Arm - 714
Quantum Dot - 716
X Majorana Zero Mode (MZM)

FIG. 8

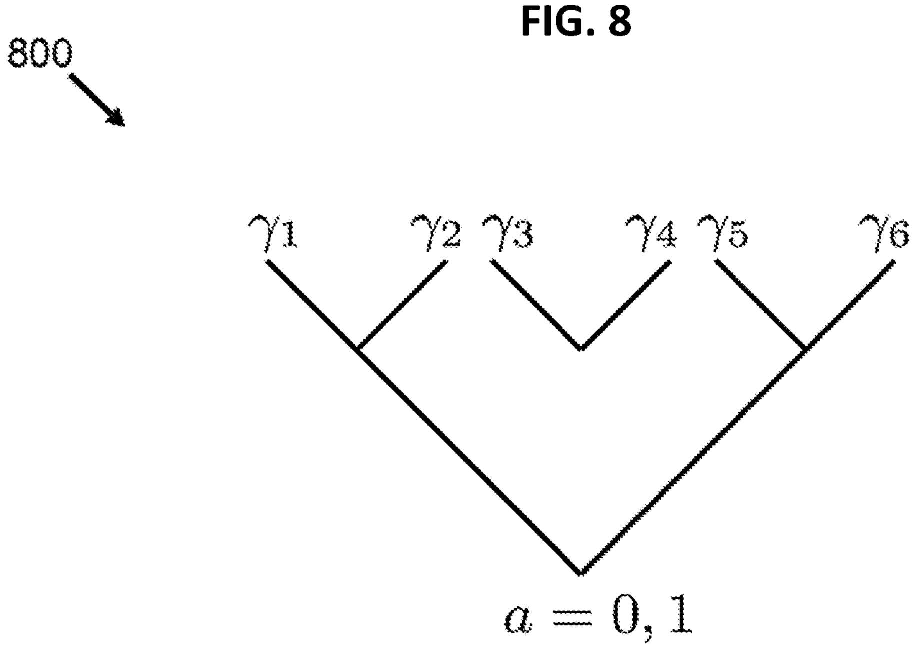
800
$\gamma_1$
$\gamma_2$
$\gamma_3$
$\gamma_4$
$\gamma_5$
$\gamma_6$
$a = 0, 1$

FIG. 9

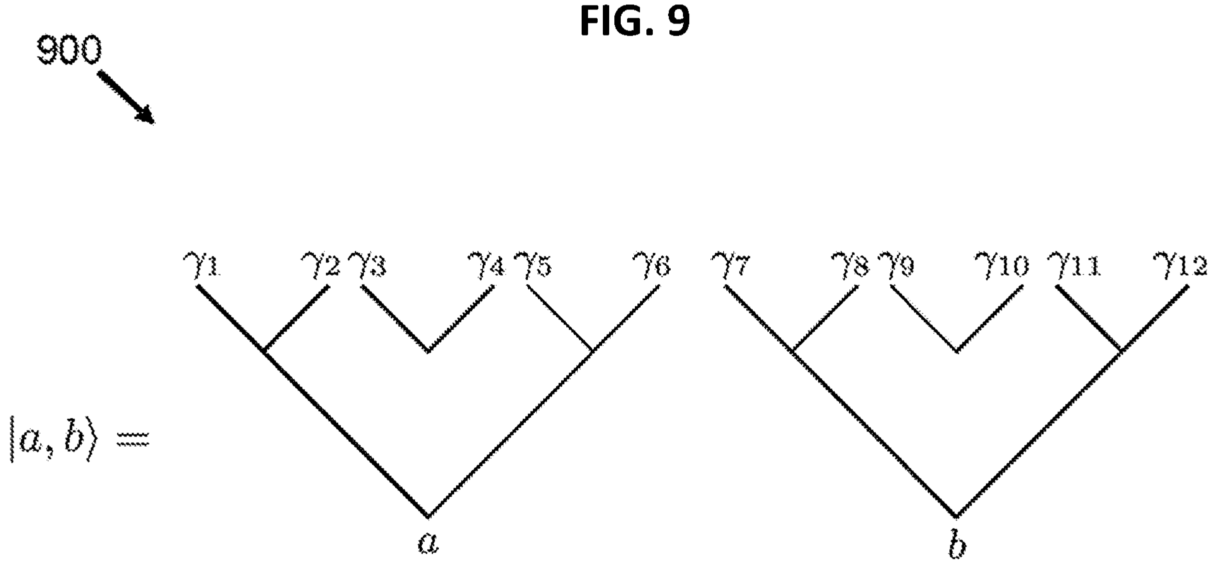
900
$|a, b\rangle =$
$\gamma_1$
$\gamma_2$
$\gamma_3$
$\gamma_4$
$\gamma_5$
$\gamma_6$
$\gamma_7$
$\gamma_8$
$\gamma_9$
$\gamma_{10}$
$\gamma_{11}$
$\gamma_{12}$
$a$
$b$

FIG. 10

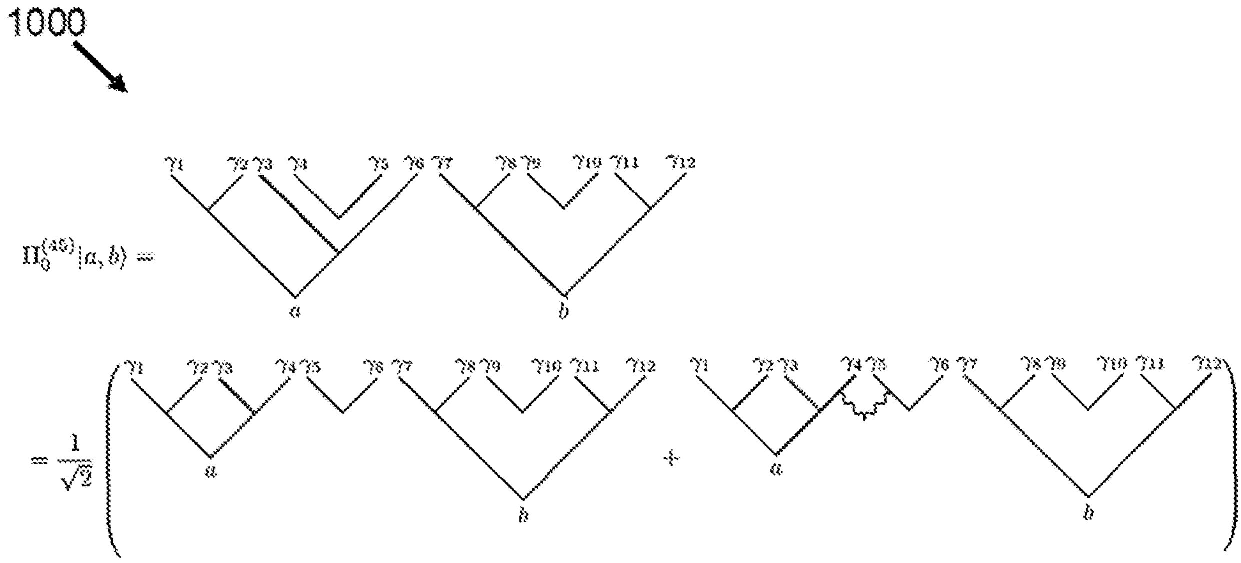
1000
Π_0^(45)|a, b⟩ =
γ1 γ2 γ3 γ4 γ5 γ6 γ7 γ8 γ9 γ10 γ11 γ12
a
b
= 1/√2
+

FIG. 11

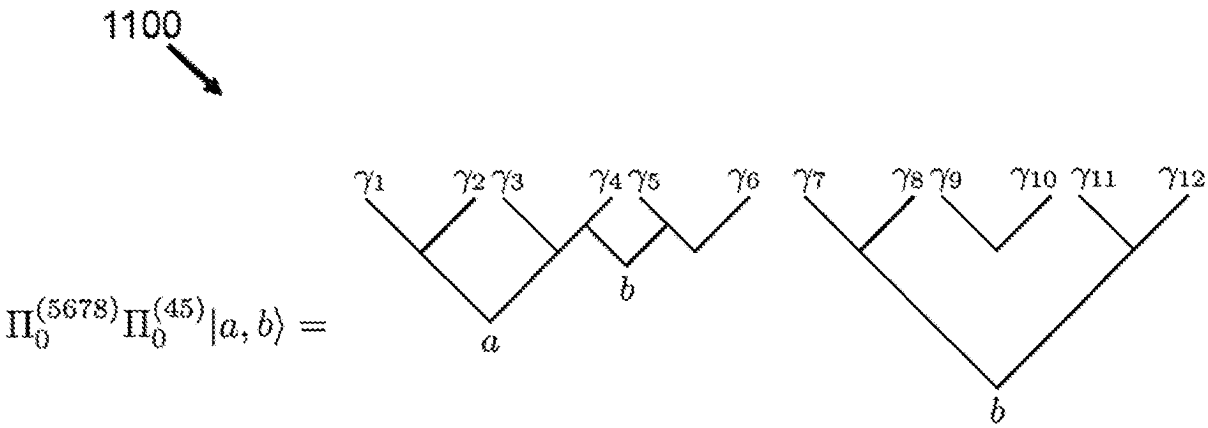
1100
Π_0^(5678) Π_0^(45)|a, b⟩ =
γ1 γ2 γ3 γ4 γ5 γ6 γ7 γ8 γ9 γ10 γ11 γ12
a
b
b

FIG. 12

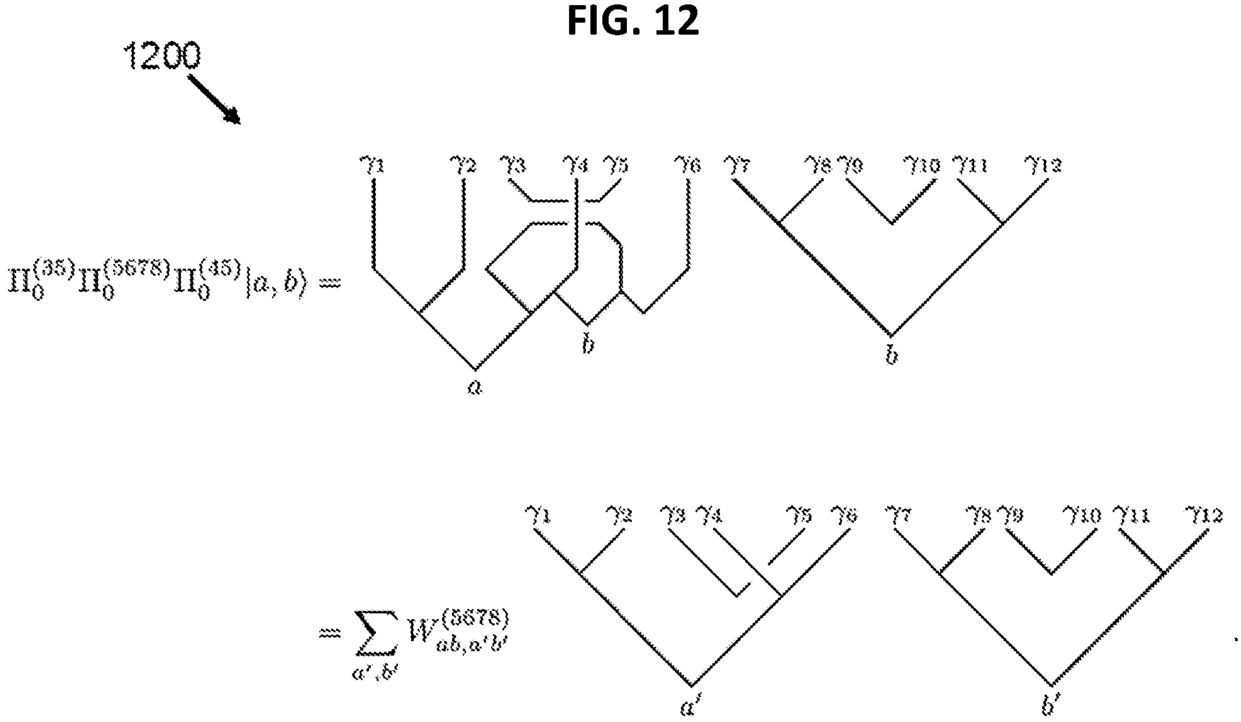
1200
$\Pi_0^{(35)}\Pi_0^{(5678)}\Pi_0^{(45)}|a,b\rangle =$
$\gamma_1$ $\gamma_2$ $\gamma_3$ $\gamma_4$ $\gamma_5$ $\gamma_6$ $\gamma_7$ $\gamma_8$ $\gamma_9$ $\gamma_{10}$ $\gamma_{11}$ $\gamma_{12}$
$a$ $b$ $b$
$= \sum_{a',b'} W^{(5678)}_{ab,a'b'}$
$\gamma_1$ $\gamma_2$ $\gamma_3$ $\gamma_4$ $\gamma_5$ $\gamma_6$ $\gamma_7$ $\gamma_8$ $\gamma_9$ $\gamma_{10}$ $\gamma_{11}$ $\gamma_{12}$
$a'$ $b'$

FIG. 13

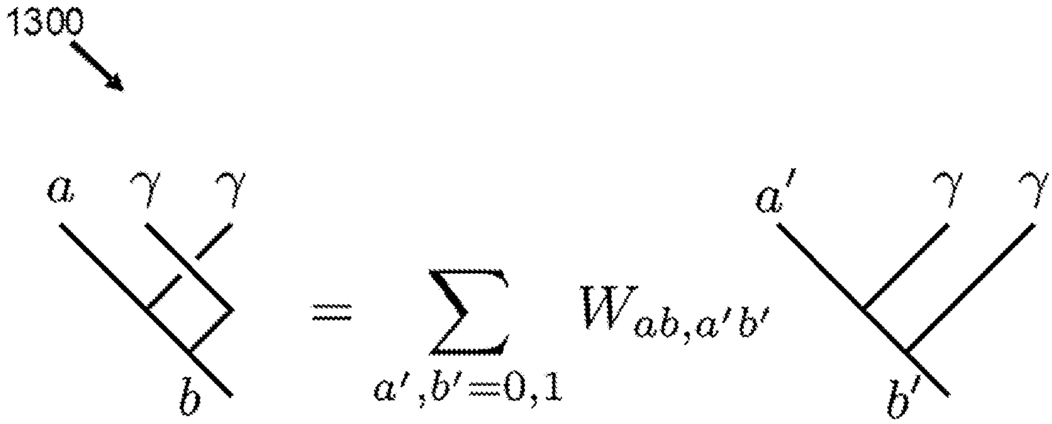
1300
$a$ $\gamma$ $\gamma$
$b$
$= \sum_{a',b'=0,1} W_{ab,a'b'}$
$a'$ $\gamma$ $\gamma$
$b'$

FIG. 14

1400

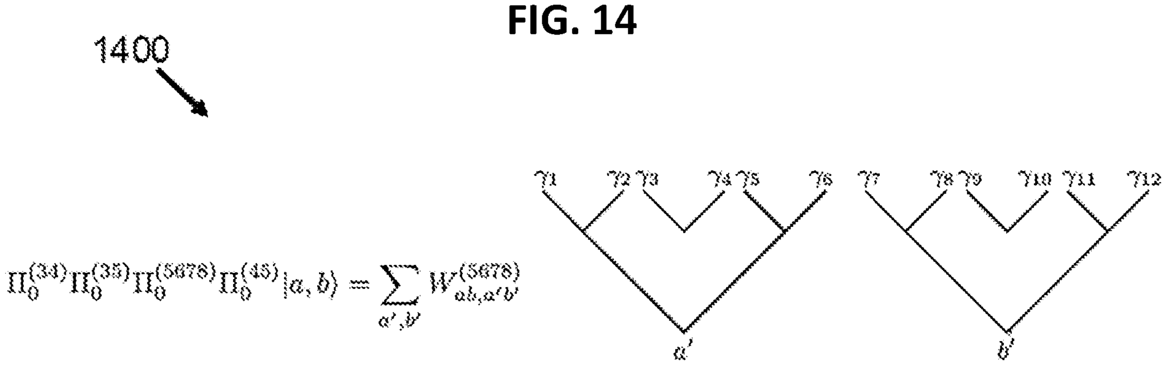


FIG. 15

1500

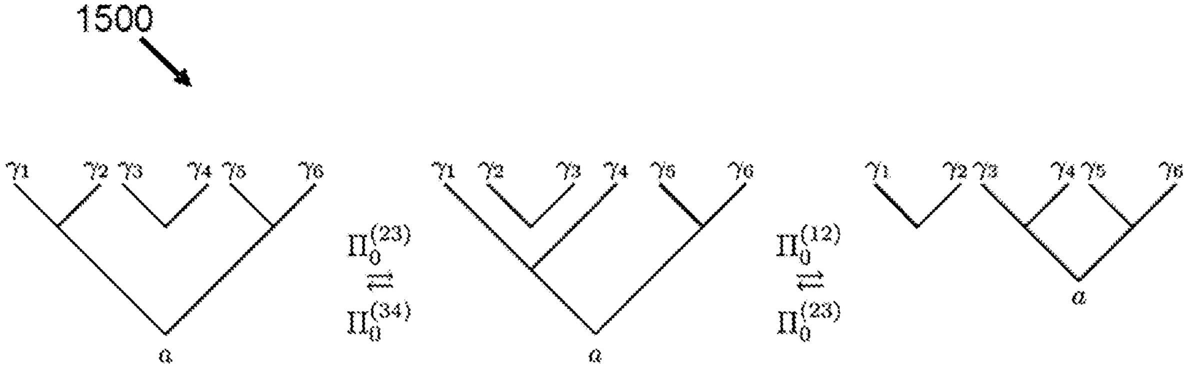


FIG. 16

1600

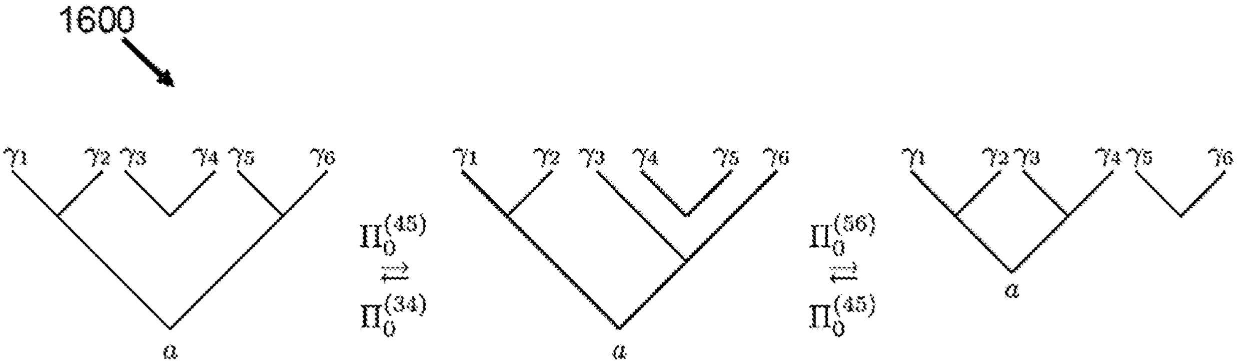

FIG. 17

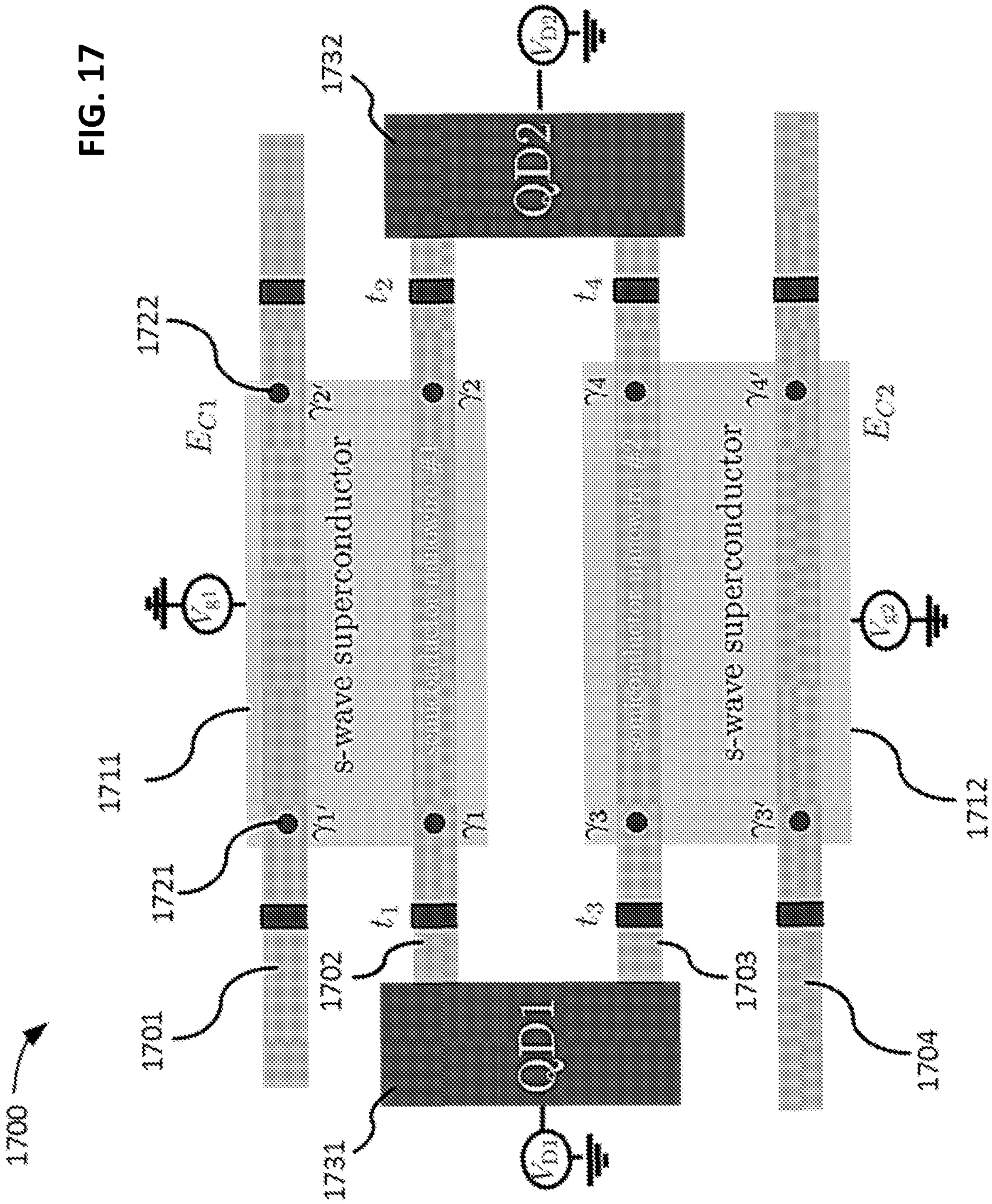

1700
1701
1702
1703
1704
1711
1712
1721
1722
1731
1732
QD1
QD2
s-wave superconductor
s-wave superconductor
$t_1$
$t_2$
$t_3$
$t_4$
$\gamma_1$
$\gamma_1'$
$\gamma_2$
$\gamma_2'$
$\gamma_3$
$\gamma_3'$
$\gamma_4$
$\gamma_4'$
$E_{C1}$
$E_{C2}$
$V_{g1}$
$V_{g2}$
$V_{D1}$
$V_{D2}$

FIG. 18

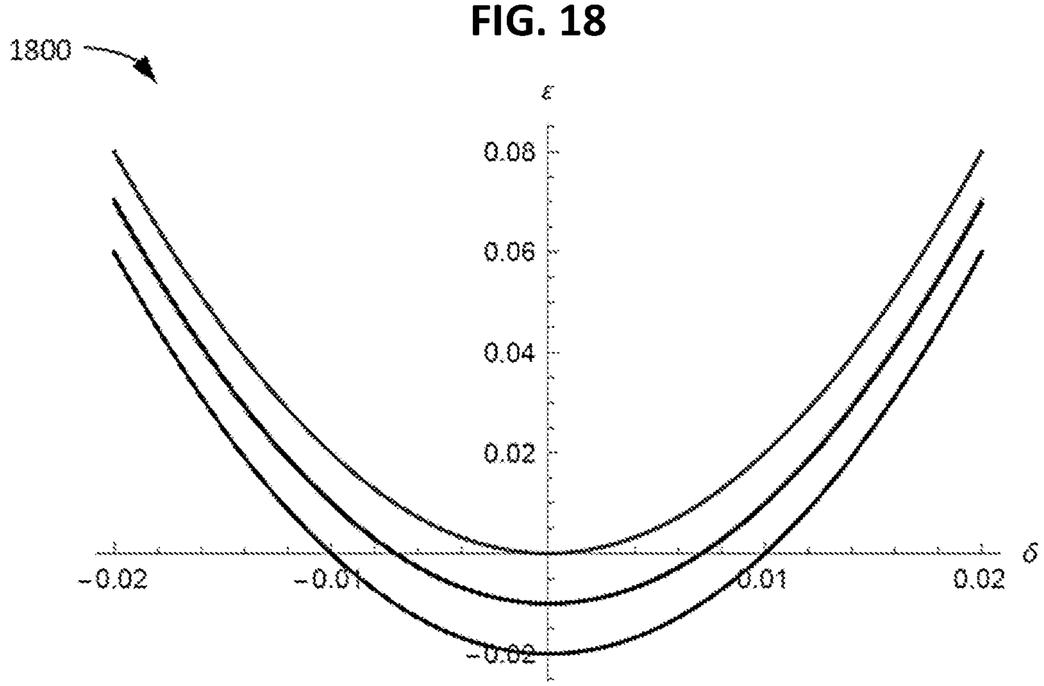
1800
ε
0.08
0.06
0.04
0.02
−0.02
−0.02
−0.01
0.01
0.02
δ

FIG. 19

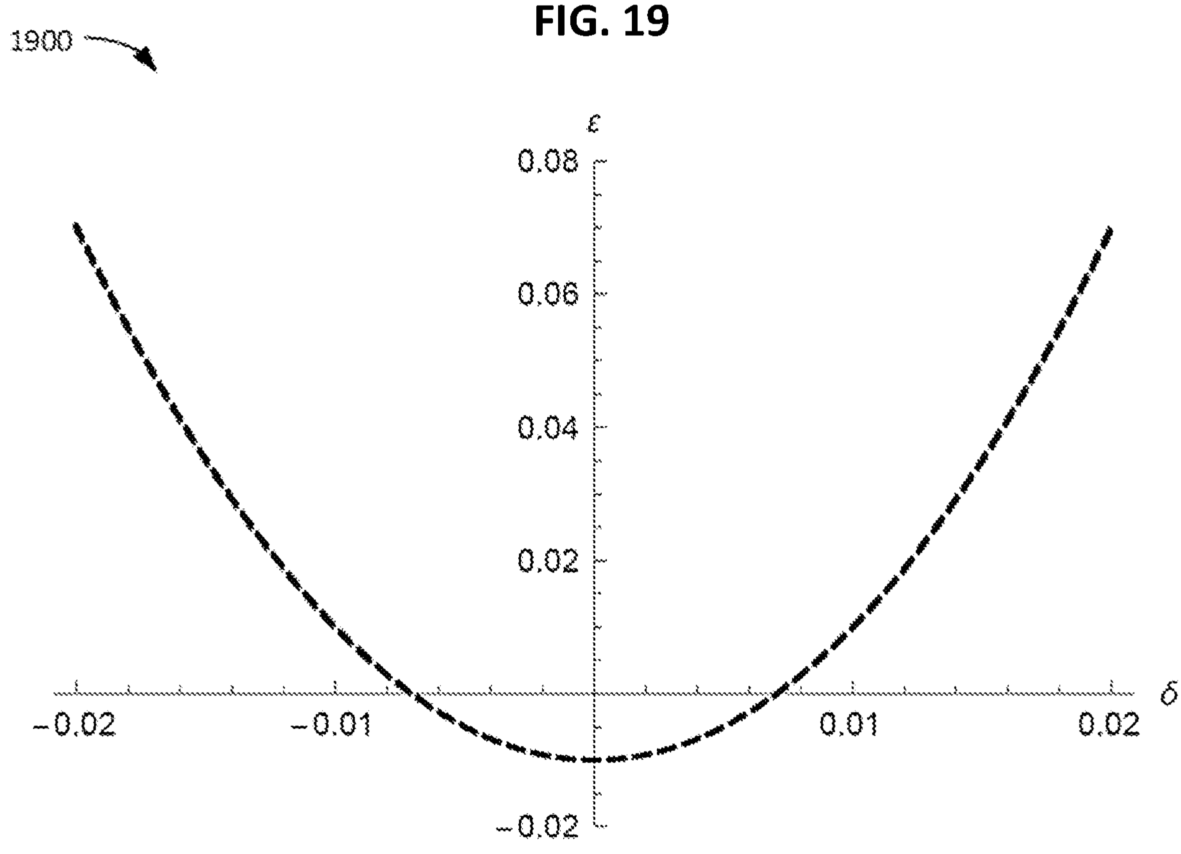
1900
ε
0.08
0.06
0.04
0.02
−0.02
−0.02
−0.01
0.01
0.02
δ

2000

FIG. 20

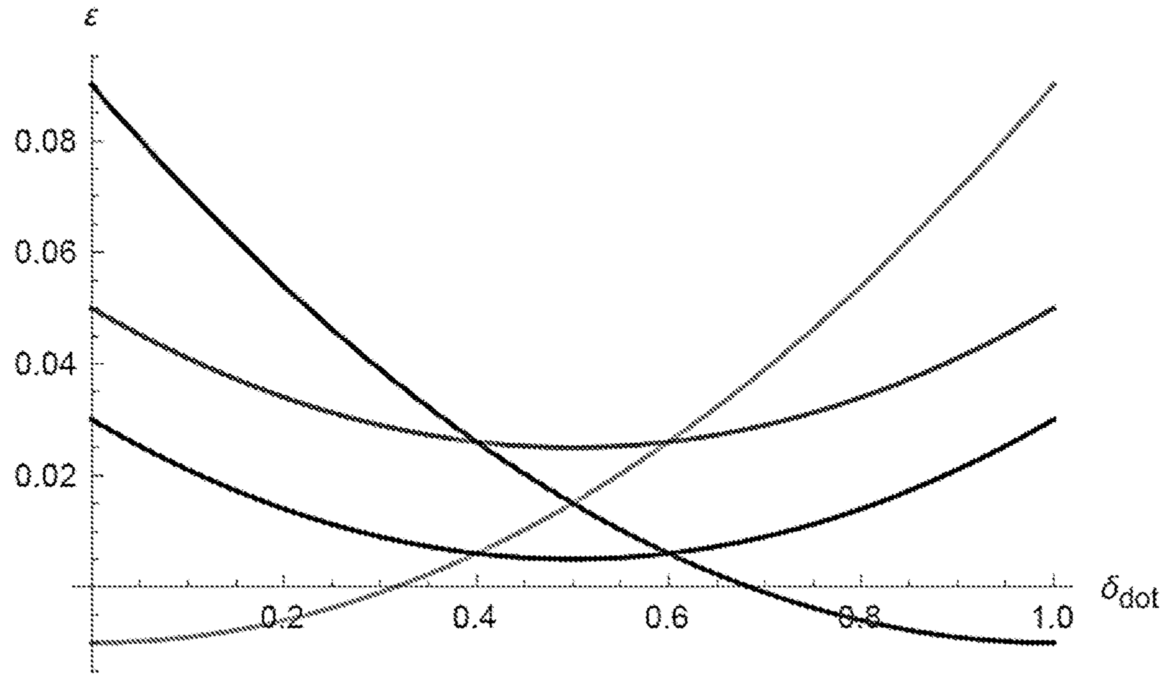


FIG. 21

2100

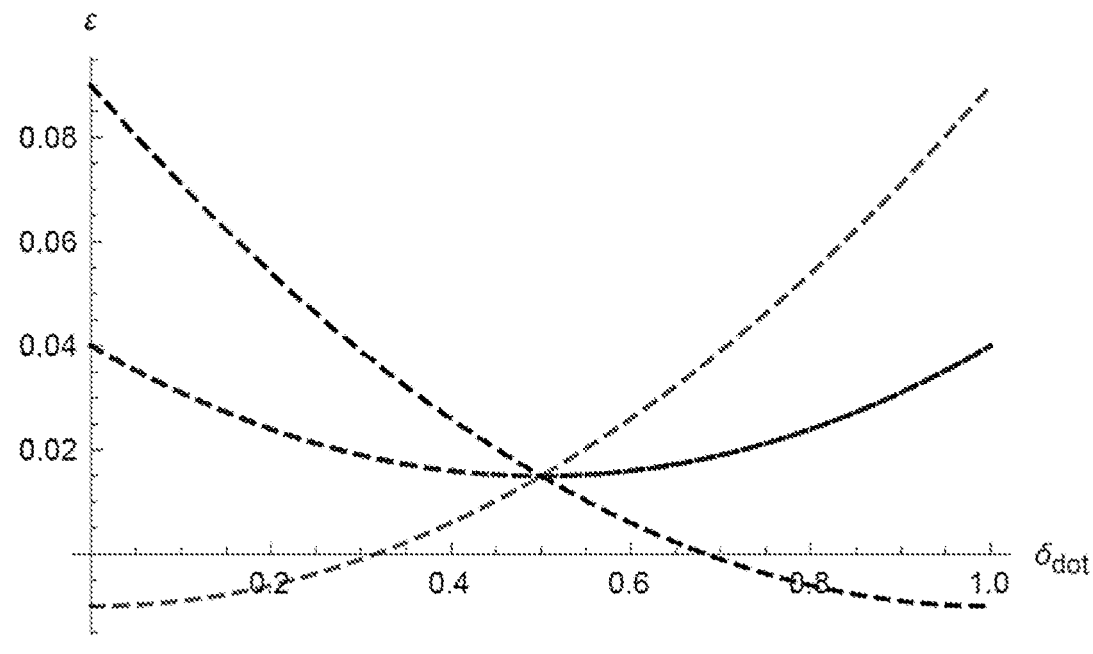

2200

# FIG. 22

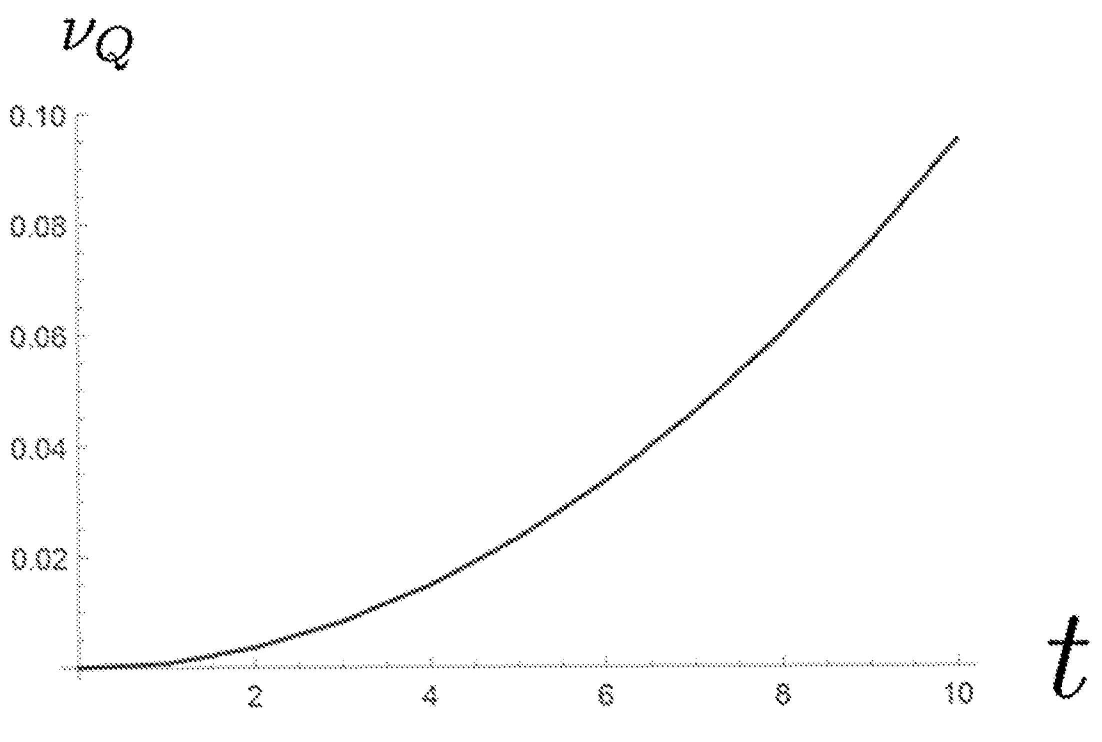

FIG. 23

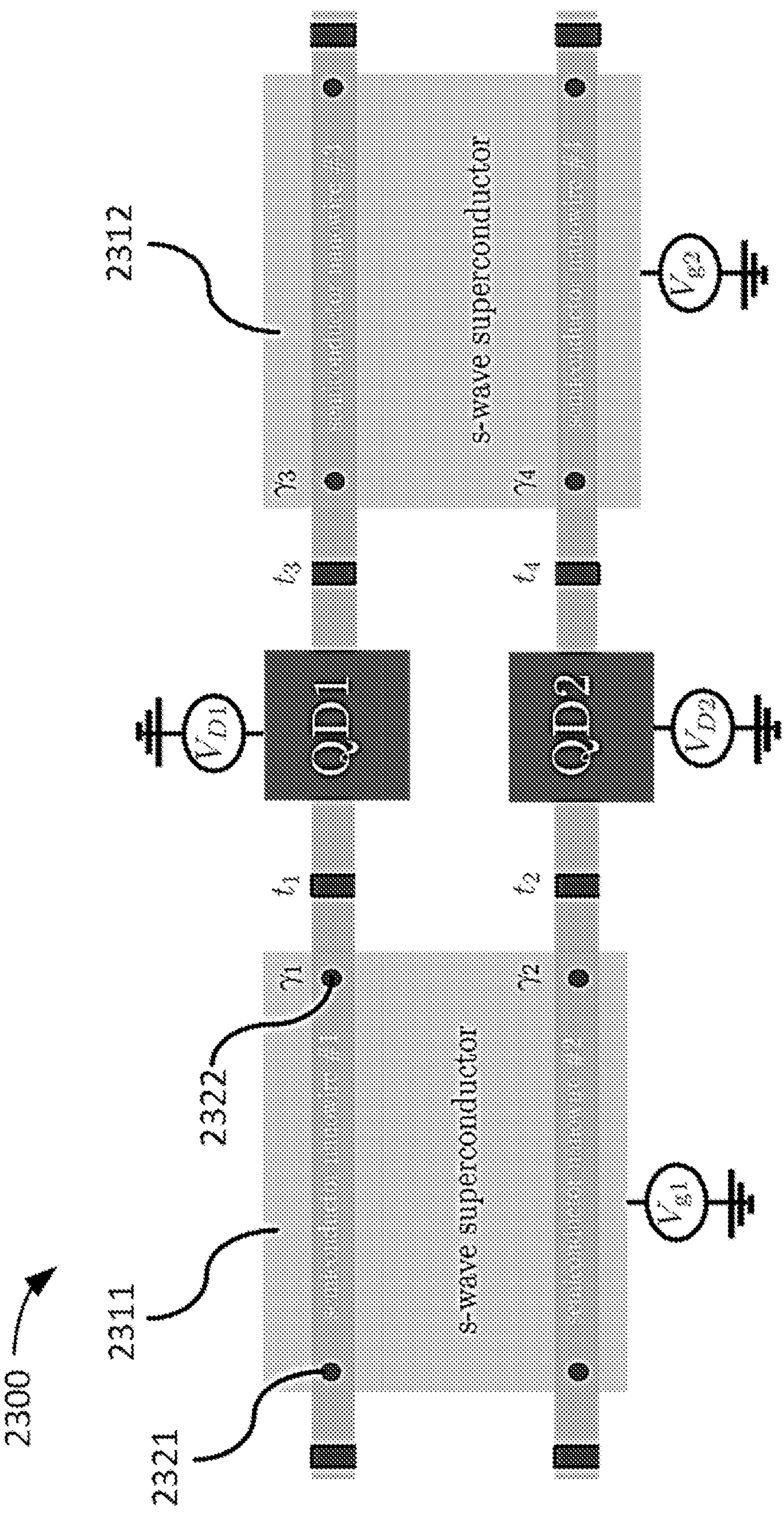
2300
2311
2312
2321
2322
s-wave superconductor
s-wave superconductor
QD1
QD2
$V_{D1}$
$V_{D2}$
$V_{g1}$
$V_{g2}$
$t_1$
$t_2$
$t_3$
$t_4$
$\gamma_1$
$\gamma_2$
$\gamma_3$
$\gamma_4$

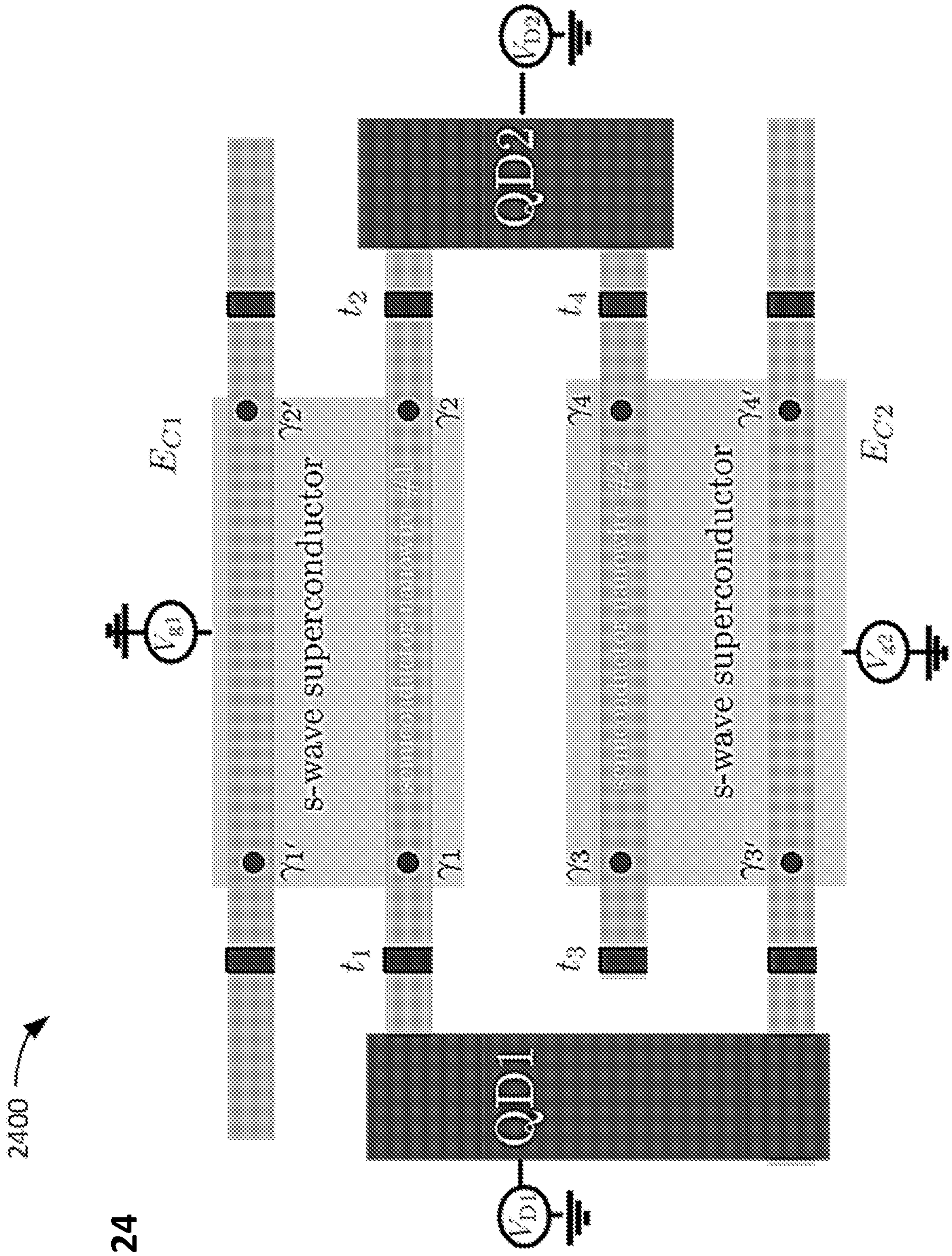
2400
QD1
QD2
s-wave superconductor
s-wave superconductor
$V_{D1}$
$V_{D2}$
$V_{g1}$
$V_{g2}$
$E_{C1}$
$E_{C2}$
$t_1$
$t_2$
$t_3$
$t_4$
$\gamma_1$
$\gamma_1'$
$\gamma_2$
$\gamma_2'$
$\gamma_3$
$\gamma_3'$
$\gamma_4$
$\gamma_4'$

FIG. 24

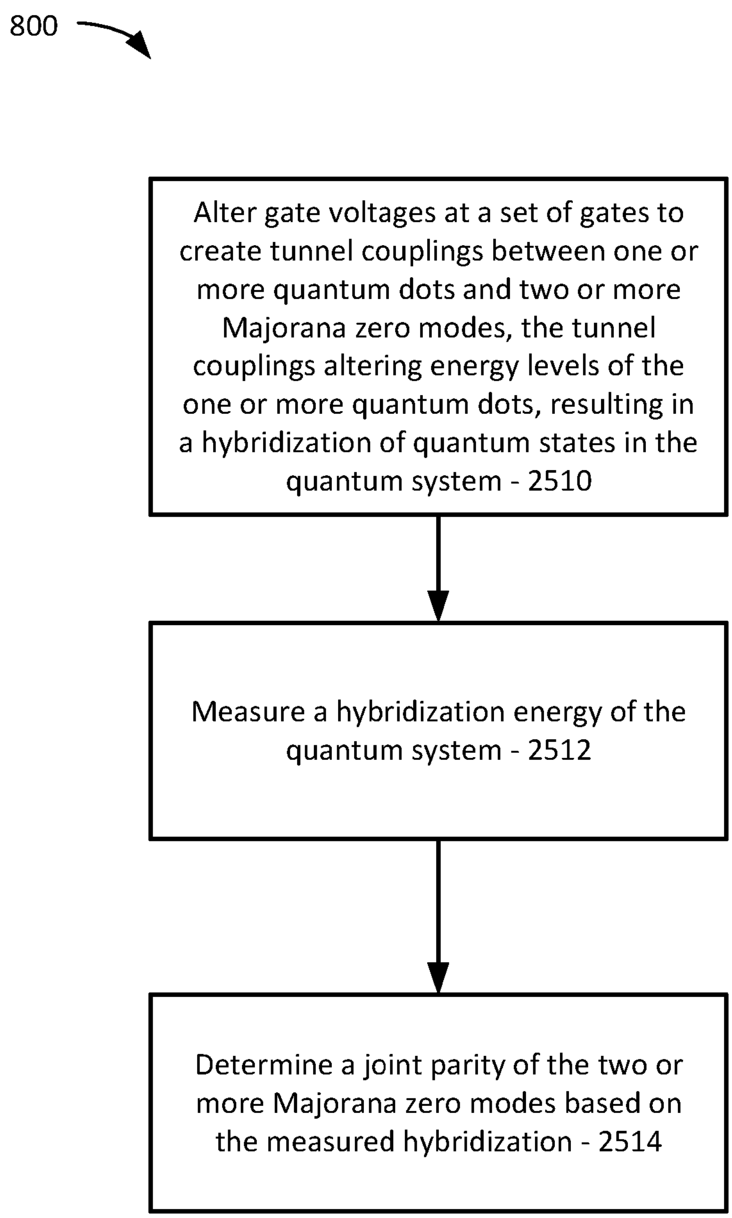
800
Alter gate voltages at a set of gates to create tunnel couplings between one or more quantum dots and two or more Majorana zero modes, the tunnel couplings altering energy levels of the one or more quantum dots, resulting in a hybridization of quantum states in the quantum system - 2510
Measure a hybridization energy of the quantum system - 2512
Determine a joint parity of the two or more Majorana zero modes based on the measured hybridization - 2514

FIG. 25

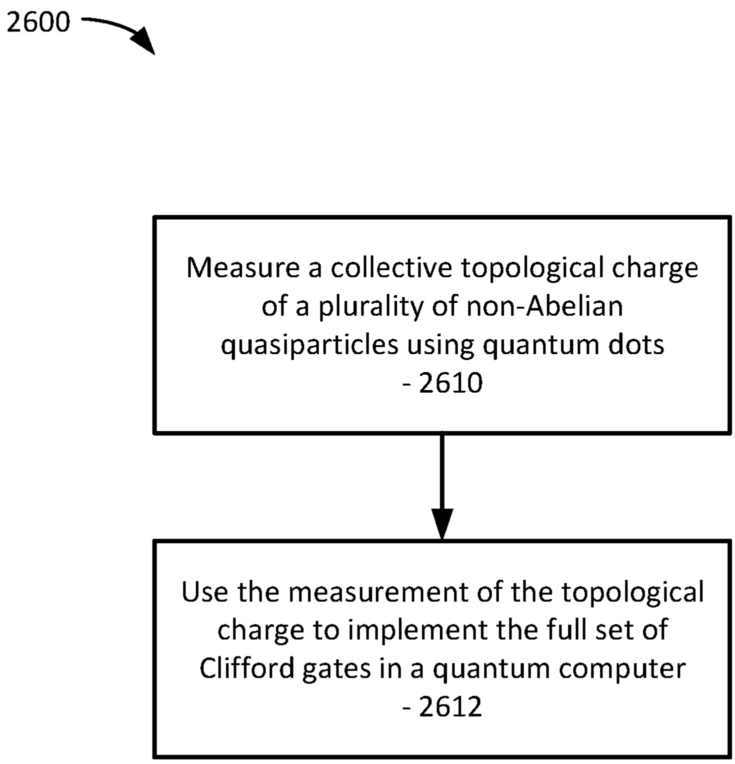
2600
Measure a collective topological charge of a plurality of non-Abelian quasiparticles using quantum dots - 2610
Use the measurement of the topological charge to implement the full set of Clifford gates in a quantum computer - 2612

FIG. 26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 63498317
- US 8209279 B
- US 62378218
- US 62376386 A
- US 9256834 B
- US 8620855 B


### Non-patent literature cited in the description


- **S. PLUGGE et al.** Roadmap to Majorana Surface codes. *Physical Review B,* vol. 94 (17), ISSN 2469-995, 78
- Non-Abeliean statistics and topological quantum informatin processing in 1D wire networks. **JASON ALICEA et al.** ARXIV.ORG. Cornell University Library, June 2010
- **L.A. LANDAU et al.** Towards Realistic Implementations of a Majorana Surface Code. *Physical Review Letters,* 01 February 2016, vol. 116 (5), ISSN 0031-9007
- **T. KARZIG et al.** Scalable Designs for Quasiparticle-Poisoning-Protected Topological Quantum Computation with Majorana Zero Modes. *arXiv: 1610.05289,* March 2017
- **T. KARZIG et al.** Scalable Designs for Quasiparticle-Poisoning-Protected Topological Quantum Computation with Majorana Zero Modes. *Phys. Rev. B,* 2017, vol. 95, 235305
- *Phys. Rev. B,* 2013, vol. 87, 195451
- *Phys. Rev. Lett.,* 2008, vol. 101, 010501
- *Annals Phys.,* 2009, vol. 324, 787-826
- *Phys. Rev. B,* 2013, vol. 87, 035113
- *Phys. Rev. B,* 2013, vol. 88, 035121
- *Phys. Rev. Lett.,* 2016, vol. 116, 050501
- *Phys. Rev. A,* 2005, vol. 71, 022316
- *Phys. Rev. X,* 2016, vol. 6, 31019
- *Nature Nanotechnology,* 2015, vol. 10, 232
- *Nature Materials,* 2015, vol. 14, 400
- *Nature Physics,* 2011, vol. 7, 412
- *Phys. Rev. B,* 2016, vol. 93, 155402
- **J. SHABANI et al.** Two-dimensional epitaxial superconductor-semiconductor heterostructures: A platform for topological superconducting networks. *Phys. Rev. B,* 2016, vol. 93, 155402
- **H. SUOMINEN et al.** Scalable Majorana Devices. *arXiv: 1703.03699*
- **PETERSSON et al.** *Nano Lett.,* 2010, vol. 10, 2789
- **COLLESS et al.** *Phys. Rev. Lett.,* 2013, vol. 110, 46805
- *Phys. Rev. Lett.,* 2010, vol. 105, 077001
- *Phys. Rev. Lett.,* vol. 105, 177002
- *Phys. Rev. Lett.,* 2010, vol. 104, 056402
- **T. KARZIG et al.** Scalable Designs for Quasiparticle-Poisoning-Protected Topological Quantum Computation with Majorana Zero Modes. *arXiv:1610.05289,* March 2017
- **R. M. LUTCHYN ; J. D. SAU ; S. DAS SARMA.** *Phys. Rev. Lett.,* 2010, vol. 105, 077001
- **Y. OREG ; G. REFAEL ; F. VON OPPEN.** *Phys. Rev. Lett.,* 2010, vol. 105, 177002
- **A. Y. KITAEV.** *Physics-Uspekhi,* 2001, vol. 44, 131